# EUROPEAN PATENT SPECIFICATION

(11) **EP 2 399 288 B1**
(45) Date of publication and mention of the grant of the patent: **15.08.2018**
(21) Application number: 10744091.9
(22) Date of filing: 08.01.2010
(51) Int. Cl.: H01L 23/48

(54) **INTEGRATED CIRCUIT MICRO-MODULE**
MIKROMODUL EINER INTEGRIERTEN SCHALTUNG
MICROMODULE À CIRCUIT INTÉGRÉ

(30) Priority: 20.02.2009 US 390349; 05.06.2009 US 479707; 05.06.2009 US 479709; 05.06.2009 US 479713; 05.06.2009 US 479715; 21.12.2009 US 643924
(43) Date of publication of application: 28.12.2011
(73) Proprietor: National Semiconductor Corporation, Santa Clara, California 95051 (US)
(72) Inventor: SMEYS, Peter, San Jose California 95120 (US); JOHNSON, Peter, Sunnyvale California 94087 (US); DEANE, Peter, Moss Beach California 94038 (US); RAZOUK, Reda R., Sunnyvale California 94087 (US)
(74) Representative: Zeller, Andreas
(86) International application number: PCT/US2010/020555
(87) International publication number: WO 2010/096213

(56) References cited:
- WO-A1-2005/104635
- US-A1- 2003 206 680
- US-A1- 2008 116 564
- US-A1- 2008 157 336
- US-A1- 2008 290 496
- US-B2- 6 734 569

## Description

### TECHNICAL FIELD

The present invention relates generally to the packaging of integrated circuits (ICs). More particularly, the present invention relates to integrated circuit micro-modules.

### BACKGROUND OF THE INVENTION

There are a number of conventional processes for packaging integrated circuit (IC) dice. Some packaging techniques contemplate the creation of electronic modules that incorporate multiple electronic devices (e.g. integrated circuits, passive components such as inductors, capacitor, resisters or ferromagnetic materials, etc.) into a single package. Packages that incorporate more than one integrated circuit die are often referred to as multi-chip modules. Some multi-chip modules include a substrate or interposer that supports various components, while others utilize a lead frame, die or other structure to support various other package components.

A few multi-chip module packaging techniques have sought to integrate multiple interconnect layers into the package using, for example, laminated films or multiple stacked chip carriers. While existing arrangements and methods for packaging electronic modules work well, there are continuing efforts to develop improved packaging techniques that provide cost effective approaches for meeting the needs of a variety of different packaging applications.

WO2005/104635 describes an electronic module, in which method at least one component is embedded inside an insulating-material layer and contacts are made to connect the component electrically to the conductor structures contained in the electronic module. At least one thermal via, which boosts the conducting of heat away from the component, is manufactured in the insulating-material layer in the vicinity of the component.

US2008290496A1 describes a system-in-package (SiP), which includes a substrate; one or more first electronic devices mounted on the substrate by a heat radiation plate; a plurality of interlayer dielectrics sequentially formed on the substrate; and one or more second electronic devices buried between or in the interlayer dielectrics on the substrate.

### SUMMARY OF THE INVENTION

The present invention provides an integrated circuit package and methods of its manufacture as described in the claims.

To achieve the foregoing and other objects of the invention, a variety of integrated circuit package arrangements are described that are composed of a plurality of immediately adjacent stacked layers of a planarized, photo-imageable dielectric. In various embodiments at least one interconnect layer is provided between an adjacent pair of dielectric layers. An integrated circuit may be positioned within one or more of the dielectric layers such that at least one of the dielectric layers extends over the active surface of the integrated circuit. The integrated circuit may be electrically coupled with I/O pads on a surface of the package through the interconnect layer and/or conductive vias that extend through corresponding dielectric layers. In particular embodiments, the package can include a heat sink, thermal pipes, multiple integrated circuits, interconnect layers, and/or conductive vias that electrically connect different components of the
package and/or passive devices. In some specific embodiments, the layers of epoxy are formed from a suitable epoxy such as SU-8.

In some embodiments, devices such as capacitors, resistors, inductors, magnetic components, MEMS devices, sensors, thin film battery structures, encapsulated lithium or other cells, antennas, etc. may be formed as part of an associated interconnect layer or otherwise formed in situ during fabrication of the package.

In still other embodiments, a heat sink or heat sinking or heat spreading layers may be formed within the package. Additionally or alternatively, a substrate may be provided to support the stacked dielectric layers. The package can also include thermal pipes for conducting heat from the interior to the edges of the package.

Various methods for forming an integrated circuit micro-module are described. In one aspect of the invention, layers of an epoxy are sequentially deposited over a substrate to form planarized layers of epoxy over the substrate. The epoxy layers are deposited using spin coating. At least some of the layers are photolithographic ally patterned after they are deposited and before the next epoxy layer is deposited. Openings are formed in at least some of the patterned epoxy layers after they are patterned and before the next epoxy layer is deposited. An integrated circuit is placed within one of the openings. At least one of the epoxy layers is deposited after the placement of the integrated circuit to cover the integrated circuit. At least one conductive interconnect layer is formed over an associated epoxy layer. Multiple external package contacts are formed. The integrated circuit is electrically connected with the external package contacts at least in part through one or more of the conductive interconnect layers.

The conductive interconnect layer can be formed using various techniques. In one implementation, a seed layer is deposited such that the seed layer covers the field, bottoms and sidewalls of openings in a particular epoxy layer. A photoresist layer is deposited over the seed layer. The deposited photoresist layer is photolithographically patterned. Portions of the photoresist layer are removed, which exposes portions of the seed layer. A conductive material is electroplated onto the exposed portions of the seed layer. The conductive material thus accumulates substantially concurrently on the field, the bottoms and the sidewalls of the openings in the epoxy layer. The aforementioned implementation forms an interconnect layer with at least one conductive trace and at least one conductive via.

Various embodiments use a wafer level process for forming multiple integrated circuit micro-modules substantially concurrently. Each such micro-module can include one or more integrated circuits and multiple layers of planarizing epoxy.

In some embodiments, the layers of epoxy are made of SU-8. The substrate can be formed from a variety of materials, including silicon, G10-FR4 and glass. At least a portion of the substrate can be removed using backgrinding or another suitable process.

Various apparatuses and methods for improving the dissipation of heat from integrated circuit micro-modules are described. One aspect of the invention pertains to an integrated circuit package with one or more thermal pipes. In this aspect, the integrated circuit package includes multiple layers of a cured, planarizing dielectric. An electrical device is embedded within at least one of the dielectric layers. At least one electrically conductive interconnect layer is embedded within one or more of the dielectric layers. A thermal pipe made of a thermally conductive material is embedded in at least one associated dielectric layer. The thermal pipe thermally couples the electrical device with one or more external surfaces of the integrated circuit package.

In various embodiments, the thermal pipe can bend, branch and/or extend in substantially different directions. There can be multiple thermal pipes. Particular embodiments involve a thermal pipe that is arranged to transmit heat but not electrical data signals. The thermal pipe can thermally couple the electrical device to one or more heat sinks.

Another embodiment of the invention pertains to a method for forming an integrated circuit package with one or more thermal pipes. Layers of an epoxy are sequentially deposited over a substrate. At least some of the epoxy layers are photolithographically patterned. An electrical device is placed over one or more associated epoxy layers. An electrically conductive interconnect layer and a thermal pipe are formed over one or more associated epoxy layers. The interconnect layer and the thermal pipe can be formed substantially concurrently.

Various apparatuses and methods for forming integrated circuit packages are described. One aspect of the invention pertains to a wafer level method for packaging micro-systems. A substrate having metal vias is provided. Multiple microsystems are formed on a top surface of the substrate. Each microsystem is formed to include multiple layers of planarizing, photo-imageable epoxy, one or more interconnect layers and an integrated circuit. Each interconnect layer is embedded in an associated epoxy layer. The integrated circuit is positioned within at least an associated epoxy layer. The interconnect layers of the microsystems are formed such that at least some of the interconnect layers are electrically coupled with one or more of the metal vias in the substrate. Molding material is applied over the top surface of the substrate and the microsystems to form a molded structure. The molded structure is singulated to form individual integrated circuit packages. Each of the integrated circuit packages contains at least one microsystem.

The substrate can be made of a variety of suitable materials, including Si, G10-FR4 and glass. In one embodiment, the substrate is not prefabricated with vias. A substrate with vias can be formed by forming holes in a substrate and electroplating an electrically conductive material into the holes. The holes and vias may or may not penetrate entirely through the substrate. Various embodiments involve removing a portion of the substrate using a variety of processes (e.g., backgrinding) to expose a portion of the vias.

One embodiment involves etching a bottom surface of the substrate to form a cavity. A sensing element, which can include a wide range of sensors such as a photovoltaic cell, a biosensor, a gas sensor, an electromagnetic sensor etc., is placed or formed within the cavity. Portions of the substrate are removed to form holes in the substrate. Conductive material is electroplated into the holes to form metal vias. At least some of these metal vias are electrically coupled with the sensing element.

Another embodiment involves forming microsystems and conductive pads over a sacrificial substrate. An electrically conductive material is applied to the top surface of the substrate to form substrate bond pads. Multiple microsystems are formed on the top surface of the substrate. Each of the microsystems includes multiple adjacent stacked layers of planarizing, photo-imageable epoxy, one or more interconnect layers and one or more integrated circuits. At least one of the interconnect layers is formed such it is electrically coupled with one or more of the substrate bond pads. Molding material is applied over the top surface of the wafer to form a molded wafer structure, thereby encapsulating each one of the microsystems. The molded wafer structure is singulated to form individual integrated circuit packages. Each integrated circuit package includes at least one of the plurality of microsystems. At least some of the substrate is removed to expose the substrate bond pads.

Various embodiments pertain to apparatuses that result from the performance of some or all of the operations in the aforementioned methods. For example, one embodiment involves a substrate with metal vias and/or electrically conductive bonding pads on its top surface. Multiple microsystems are formed on the top surface of the substrate. The top surface of the substrate and the microsystems are covered with molding material.

Various apparatuses and methods for forming integrated circuit packages are described. One aspect of the invention pertains to a method for forming a microsystem and one or more passive devices in the microsystem. Layers of epoxy are sequentially deposited over a substrate to form multiple planarized layers of epoxy over the substrate. The epoxy layers are deposited by spin coating. At least some of the epoxy layers are photolithographically patterned after they are deposited and before the next epoxy layer is deposited. An integrated circuit having multiple I/O bond pads is placed on an associated epoxy layer. At least one conductive interconnect layer is formed over an associated epoxy layer. A passive component is formed within at least one of the epoxy layers. The passive component is electrically coupled with the integrated circuit via at least one of the interconnect layers. Multiple external package contacts are formed. The integrated circuit is electrically connected to the external package contacts at least partly through one or more of the conductive interconnect layers. The above operations can be performed on a wafer level to form multiple microsystems substantially concurrently.

One or more passive components can be positioned in a wide variety of locations within a microsystem. Passive components can be formed to serve various purposes. For example, the passive component may be a resistor, a capacitor, an inductor, a magnetic core, a MEMS device, a sensor, a photovoltaic cell or any other suitable device.

Various techniques can be employed to form passive devices. For example, each passive component can be formed substantially concurrently with other portions of the microsystem, such as another passive component and/or one or more of the interconnect layers. In some embodiments, thin film resistors may be formed by sputtering a metal over an epoxy layer. Inductor windings may be formed by sputtering or electroplating metal layers over at least one of the epoxy layers. Capacitors may be formed by sandwiching a thin dielectric layer between metal plates deposited over epoxy layers. Magnetic cores for inductors or sensors may be formed by sputtering or electroplating ferromagnetic material over an epoxy layer.

One aspect of the invention pertains to an integrated circuit package in which one or more integrated circuits are embedded in a substrate and covered with a layer of photo-imageable epoxy. An integrated circuit is positioned within a cavity in the top surface of the substrate. The epoxy layer is formed over the top surface of the substrate and the active face of the integrated circuit. An interconnect layer is formed over the epoxy layer and is electrically coupled with the integrated circuit.

Additional integrated circuits, interconnect layers and/or epoxy layers can be stacked over the substrate as desired or appropriate for a particular application. The substrate and epoxy layers can include a wide variety of components, active and passive devices, such as sensors, inductors, capacitors, resistors, thermal pipes, photovoltaic cells, etc.

The substrate can have a wide variety of features, depending on the needs of a particular application. For example, the substrate can be a doped silicon wafer that is electrically grounded and electrically and thermally coupled with one or more embedded integrated circuits and/or contacts. In one embodiment the substrate is at least partly optically transparent and optical devices within the substrate can communicate through the substrate. Still another embodiment involves an integrated circuit in a cavity of the substrate that is separated from a sidewall of the cavity by an air gap. This arrangement can help reduce stresses on the integrated circuit when it expands due to a change in temperature.

Additional embodiments of the present invention pertain to methods for forming the aforementioned integrated circuit packages.

### BRIEF DESCRIPTION OF THE DRAWINGS

The invention and the advantages thereof may best be understood by reference to the following description taken in conjunction with the accompanying drawings in which:
Figure 1 illustrates a diagrammatic cross-sectional view of a package containing multiple integrated circuits and interconnect layers in accordance with an embodiment of the present invention
Figure 2 is a process flow diagram illustrating a wafer level process for packaging integrated circuits in accordance with an embodiment of the present invention.
Figures 3A-3L illustrate diagrammatic cross-sectional views of selected steps in the process of Figure 2.
Figures 4A-4E illustrate diagrammatic cross-sectional views of packages in accordance with various alternative embodiments of the present invention.
Figures 5A-5H illustrate selected steps in a wafer level process for packaging integrated circuits in accordance with another embodiment of the present invention.
Figures 6A-6C illustrate selected steps in a wafer level process for packaging integrated circuits in accordance with another embodiment of the present invention.
Figure 7A-7C illustrate selected steps in a wafer level process for packaging integrated circuits in accordance with yet another embodiment of the present invention.
Figures 8A-8B illustrate diagrammatic cross-sectional views of packages that each include a substrate with embedded integrated circuits according to various embodiments of the present invention.
Figures 9A-9G illustrate selected steps in a wafer level process for forming packages that each include a substrate with embedded integrated circuits according to another embodiment of the present invention.
Figures 10A-10D illustrate diagrammatic cross-sectional views of package arrangements according to various embodiments of the present invention.

In the drawings, like reference numerals are sometimes used to designate like structural elements. It should also be appreciated that the depictions in the figures are diagrammatic and not to scale.

### DETAILED DESCRIPTION OF EXAMPLE EMBODIMENTS

In one aspect, the present invention relates generally to integrated circuit (IC) packages and more specifically to IC micro-module technology. This aspect involves a micro-module made of multiple layers of a dielectric that is preferably photo-imageable and readily planarized. The micro-module may contain a variety of components including one or more integrated circuits, interconnect layers, heat sinks, conductive vias, passive devices, MEMS devices, sensors, thermal pipes etc. The various components can be arranged and stacked within the micro-module in a wide variety of different ways. The layers and components of the micro-module can be deposited and processed using various conventional wafer level processing techniques, such as spin coating, spray coating, lithography and/or electroplating. Another aspect of the present invention relates to wafer level manufacturing techniques and structures that integrate multiple active and/or passive components into a single, cost-effective, high-performance package.

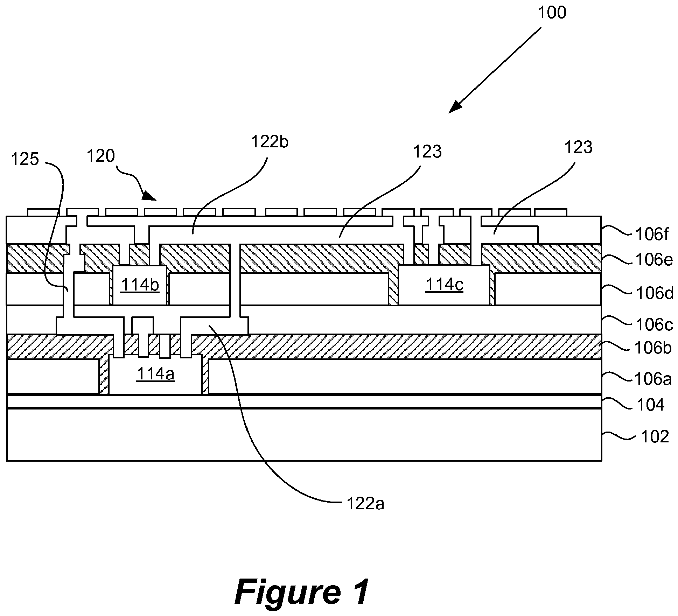

Figure 1 illustrates a package according to one embodiment of the present invention. In the illustrated embodiment, a multi-tiered package 100 includes a substrate 102, a heat sink 104, a plurality of stacked dielectric layers 106, integrated circuits 114, passive components (not shown), interconnect layers 122, vias 125 and external contact pads 120. The heat sink 104 is formed over the substrate 102 and the dielectric layers 106 are stacked on top of the heat sink. Interconnect layers are interspersed as needed between adjacent dielectric layers 106. The integrated circuits are embedded within stacked layers of an dielectric 106, and may be electrically connected to other components (e.g., other ICs, passive components, external contact pads 120, etc. by appropriate traces in the interconnect layers 122 and vias 125. In the illustrated embodiment, one of the integrated circuits (114a) is effectively mounted on the heat sink 104 to provide good heat dissipation.

The dielectric layers 106 may be made from any suitable dielectric material. In various preferred embodiments, the dielectric layers 106 are made from a material that is readily planarized and/or photo-imageable. In a particular preferred embodiment, the layers are pmade from photo-imageable, planarizing SU-8, although other suitable materials may be used as well. In some designs the dielectric used for layers 106 is highly viscous when initially applied, and is subsequently partially or fully cured during a photolithographic process. The layers 106 may be applied using a variety of suitable techniques, including spin coating and spray coating. The thickness of the various dielectric layers can vary widely in accordance with the needs of a particular application and the different layers do not need to have the same thickness (although they may have the same thickness).

The integrated circuits 114 within package 100 can be arranged in a wide variety of ways and may be placed at almost any location within the package. By way of example, different integrated circuits 114 may be positioned in the substrate 102, different photo-imageable layers and/or within the same layer. In various embodiments, the integrated circuits 114 can be stacked, positioned side-by-side, placed in close proximity to one another and/or be separated by a substantial distance relative to the overall size of package 100. Integrated circuits positioned in different layers may be positioned directly or partially over one another or they may be separated such that they do not overlie one another. Integrated circuits 114 can also have a variety of different form factors, architectures and configurations. For example, they may take the form of relatively bare dice (e.g., unpackaged dice, flip chips etc.), partially and/or fully packaged dice (e.g., BGAs, LGAs, QFNs, etc.)

The electrical interconnects within the package 100 may be arranged in a wide variety of different ways as well. The embodiment illustrated in Fig. 1 includes two interconnect (trace) layers 122a and 122b. More or fewer interconnect layers are possible in different implementations. Each interconnect layer typically has at least one (but typically many) traces 123 that are used to help route electrical signals between different components of the package. The interconnect layers 122 are generally formed on top of an associated one of the planarized dielectric layers 106. The trace layer is then buried or covered by the next dielectric layer. Thus, the interconnect layers generally extend in planes that are parallel with and embedded within the dielectric layers.

Since the interconnect layers (and potentially other components of the package) are formed on top of a dielectric layer, it is desirable for the dielectric layers 106 to have a very flat and hard surface upon which other components (e.g. traces, passive components, etc.) may be formed or discrete components (e.g. ICs) may be mounted. SU-8 is particularly well suited for this application because it readily self-planarizes when applied using conventional spin-on and spray coating techniques and it is very hard when cured. Indeed, spun on SU-8 can be used to form a hard flat surface that does not require any additional planarizing (e.g., chemical mechanical polishing) before a high quality interconnect layer is formed thereon using conventional sputtering/electroplating techniques. Dielectric materials that can be applied in this manner to form a very flat surface are referred to herein as planarizing dielectrics.

Electrically conductive vias 125 are provided to electrically connect components (e.g., ICs / traces / contacts / passive components, etc.) that reside at different layers of the package. The vias 125 are arranged to extend through an associated dielectric layer 106. By way of example, the vias 125 may be used to couple traces from two different interconnect layers together; a die or another component to an interconnect layer; a contact to a trace, die or other component, etc. As will be described in more detail below, metalized vias may be formed at the same time that an associated interconnect layer 122 is deposited by filling via openings that were earlier formed in an associated dielectric layer 106.

Package 100 can include many other types of devices than the ones illustrated in Figure 1. In the illustrated embodiment, only several integrated circuits and interconnect layers are shown. Package 100, however, can also contain almost any number of active and/or passive devices. Examples of such active and/or passive devices includes resistors, capacitors, magnetic cores, MEMS devices, sensors, cells (e.g., encapsulated lithium or others), integrated thin film battery structures, inductors, etc. These devices can be positioned and/or stacked in various locations within package 100. The components may take the form of prefabricated discrete components or may be formed in-situ. One advantage of the lithography-based process used to create package 100 is that these and other components can be formed in-situ during the layered formation of the package. That is, while prefabricated, discrete components can be placed in almost any position within package 100, components can also be fabricated directly onto any photo-imageable layer 106 using any suitable technique, such as conventional sputtering and/or electroplating. Due to the nature of this fabrication process, superior matching, precision and control can be achieved and low stress packaging is possible over various die and/or substrate sizes, including medium and large ones.

The substrate 102 may be made of any suitable material, including silicon, glass, steel, quartz, G10-FR4, any other FR4 family epoxy, etc. Depending on the needs of a particular application, the substrate can be electrically conductive, electrically insulating and/or optically transparent. In some embodiments, the substrate is used only as a carrier during fabrication and is accordingly removed before the package is completed. In other embodiments, the substrate remains an integral part of the package. If desired, the substrate 102 may be thinned after assembly by backgrinding or other suitable techniques. In still other embodiments, the substrate may be omitted entirely.

In some embodiments, the substrate 102 can integrate one or more sensors (not shown.) This approach enables the integration of sensor components without the packaging and reliability concerns often associated with the sensor's requirements to be exposed to the environment. Sensors can be mounted on either side of the substrate 102 and can be embedded or exposed to the environment through etched windows or microchannels. Examples of suitable sensors include but are not limited to biosensors, sensors for gas, chemical, electromagnetic, acceleration, vibration, temperature, humidity etc.

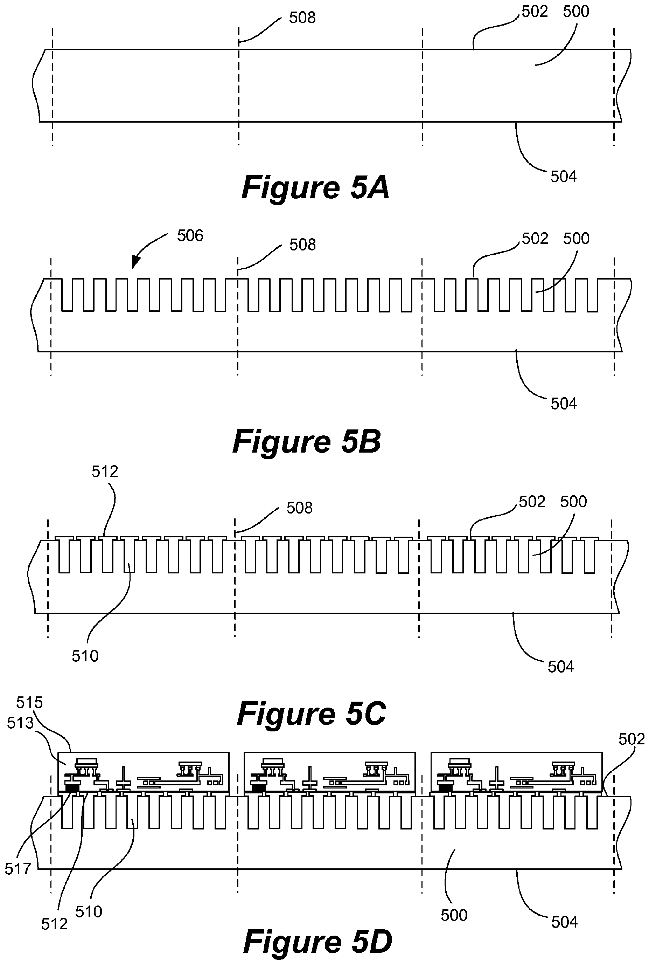

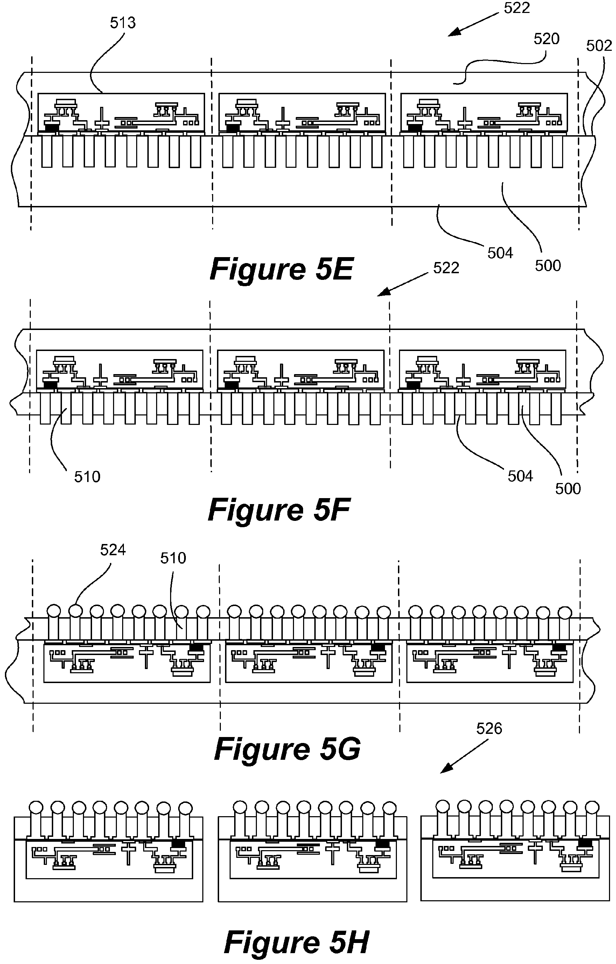

One approach is to integrate a sensing element into the backside of the substrate 102. The sensing element can be built inside a deep cavity in the substrate 102 that has been etched from the backside of the substrate 102. For example the sensing element may be a capacitor made from electroplated Cu fingers. The capacitor can be connected with contact pads on the frontside of the substrate 102 through micro-vias. Package 100 can be formed over these contact pads such that the capacitor is electrically coupled with at least some of the electrical devices and interconnect layers within package 100. The sensing element inside the cavity that is created on the backside of the wafer can be filled with the gas sensitive material and can be automatically exposed to the environment, while the active circuitry on the frontside of substrate 102 can be protected by conventional encapsulation techniques, such as those discussed below in connection with Figure 5E.

Package 100 also includes a system for dissipating internally generated heat, which can include thermal pipes and heat sinks, such as heat sink 104. Such a system can play an important role in the performance of the package 100, because packages with high power densities and multiple embedded devices may need to have good heat dissipation to function properly. The thermal pipes and heat sinks are generally formed at substantially the same time and using the same techniques as the interconnect layers 122. Such thermal pipes can penetrate and/or wind through one or more interconnect layers and/or photo-imageable layers. Any single, continuous thermal pipe, trace and/or via can branch off into multiple other traces and/or vias at almost any point and can extend in more than one direction, such as laterally and/or vertically within the package. The thermal pipes can thermally couple virtually any device within the package 100 with one or more heat dissipation pads and/or heat sinks located on the exterior of the package 100.

The heat sink 104 can have a variety of different architectures. In the illustrated embodiment heat sink 104 forms a layer having a footprint that substantially matches the footprint of the photo-imageable layers of package 100. Alternatively, the package 100 could include one or more heat sinks whose dimensions at least partly match those of an overlying or underlying active device, such as an integrated circuit. In the illustrated embodiment, the heat sink takes the form of a layer or sheet 104 formed over the substrate and forms a base for the dielectric layers 106. If desired, integrated circuits 104 can be mounted directly on the heat sink layer as illustrated by integrated circuit 114(a). Alternatively, thermally conductive vias (not shown) may be used to improve the thermal path between a buried integrated circuit and the heat sink as illustrated by integrated circuit 114(b). In some embodiments, the heat sink(s) or heat sink layer(s) are exposed on a top or bottom surface of the package. In others, a substrate or other layer may cover the heat sink(s) or heat sink layers such that the heat sinks function as heat spreaders. The heat sink(s) 104 may be made of a variety of suitable conductive materials, such as copper and may be formed in the same manner as the interconnect layers.

Various embodiments of the package 100 can incorporate a variety of other features as well. For example, package 100 can incorporate high voltage (HV) isolation and an embedded inductive galvanic capability. It can feature wireless interfaces e.g., RF antennas for wireless system IO, EM power scavenging, RF shielding for EMI sensitive application, etc. In various embodiments, package 100 can include power management subsystems e.g., superchargers, integrated photovoltaic switches etc. The package 100 could be formed on a wafer and encapsulated e.g., as shown in Figure 5E. Sensing surfaces and materials can be integrated into other processing steps for the package 100 and the wafer e.g., as discussed above and in connection with Figures 5A-5H, 6A-6C and 7A-7C.

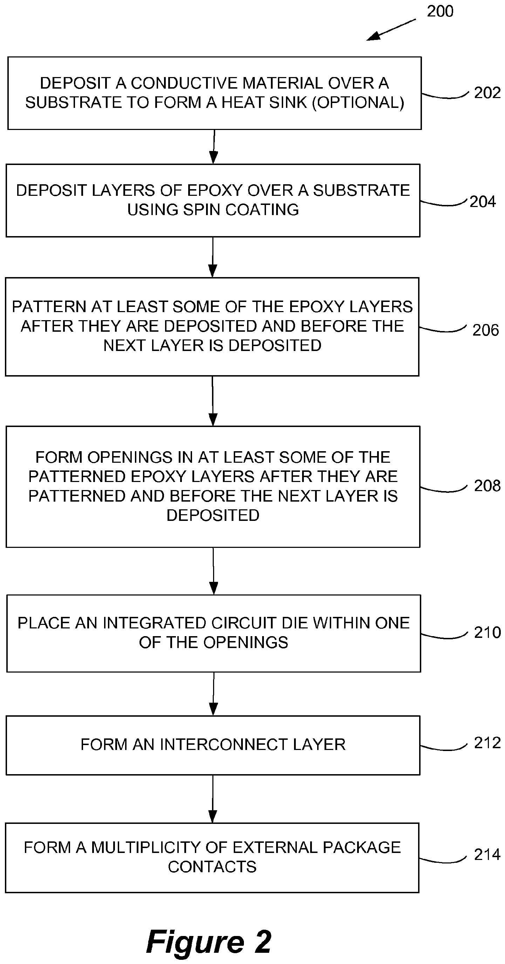

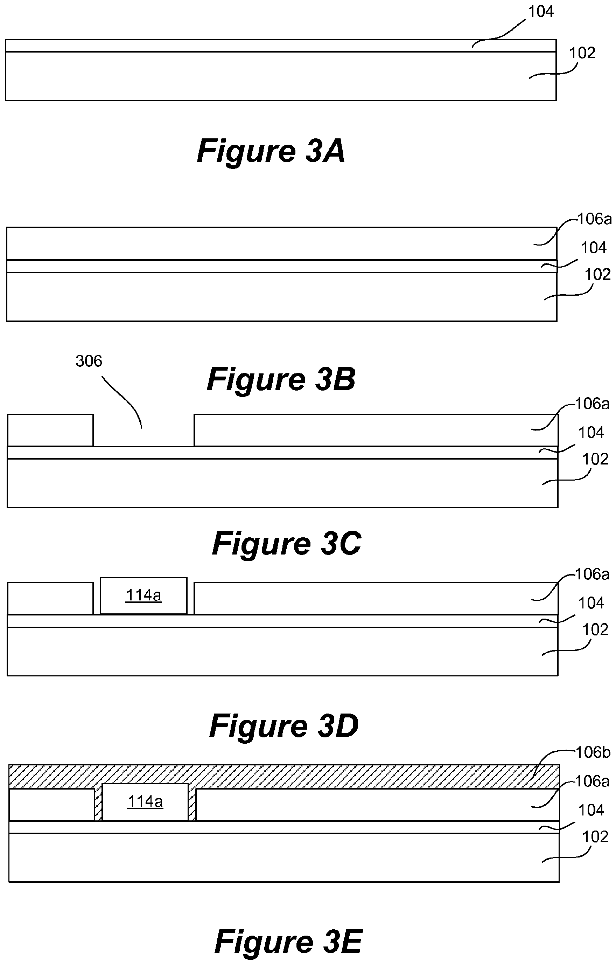

Referring next to Figure 2, a wafer level method 200 for forming integrated circuit package 100 according to an embodiment of the present invention will be described. The steps of method 200 are illustrated in Figures 3A-3L. The steps of method 200 may be repeated and/or performed out of the illustrated order. It should be noted that the process depicted in method 200 may be used to concurrently form many structures other than those shown in Figures 3A-3L.

Initially, in step 202 of Figure 2, an optional conductive layer 104 of Figure 3A is formed over a substrate 102 using any of a variety of suitable techniques. By way of example, sputtering of a seed layer followed by conventional electroplating works well. Of course other suitable conductive layer formation techniques may be used as well. The conductive layer 104 functions as a heat sink and may be made of various materials, such as copper or other appropriate metals or metal layer stacks. The substrate 102 may be a wafer and can be made of a variety of suitable materials, such as silicon, G10-FR4, steel, glass, plastic, etc.

In Figure 3B, a layer of planarizing, photo-imageable epoxy 106a is deposited over the heat sink 104 (step 204 of Figure 2). This can be done using a variety of techniques, such as spin coating, spray coating or sheet lamination. In the illustrated embodiment, the epoxy layer 106a is SU-8, although other appropriate dielectric materials may be used. SU-8 is well suited for applications using conventional spin-on coating techniques.

SU-8 has various advantageous properties. It is a highly viscous, photo-imageable, chemically inert polymer that can solidify when exposed to UV radiation, for example, during a photolithographic process. SU-8 provides greater mechanical strength relative to some other known photoresists, is resistant to overpolishing and is mechanically and thermally stable at temperatures up to at least 300°C. It planarizes easily and evenly using spin coating relative to certain other photo-imageable materials such as BCB, which allows it to be readily used as a base upon which interconnects or passive components may be fabricated, and upon which integrated circuits or other passive components may be mounted. It can readily be used to create dielectric layers with thicknesses in the range of 1 um to 250 um and both thinner and thicker layers are possible. In particular embodiments, openings can be formed in SU-8 having high aspect ratios (e.g. approximately 5:1 or greater) which facilitates the formation of components such as conductive vias or other structures with high aspect ratios. By way of example, aspect ratios of 7:1 are readily obtainable. Relative to many other materials, superior control, precision and matching can be achieved with SU-8 layers, which can result in higher densities and improved performance. Other suitable dielectric materials with one or more of the above characteristics may also be used in place of SU-8.

In step 206 of Figure 2, epoxy layer 106a is patterned using conventional photolithographic techniques. In one embodiment, a mask is used to selectively expose portions of the epoxy layer 106a. The exposure can be followed by a baking operation. These operations can cause the exposed portions of the epoxy layer 106a to crosslink. During the photolithographic process, exposed portions of epoxy layer 106a may be cured, partially cured (e.g., B-staged) or otherwise altered or hardened relative to the unexposed portions to facilitate later removal of unexposed portions of the epoxy.

In step 208 of Figure 2 and Figure 3C, unexposed portions of the epoxy layer 106a are removed to form one or more openings 306 in the epoxy layer 106a. This removal process can be performed in a variety of ways. For example, the epoxy layer 106a can be developed in a developer solution, resulting in the dissolution of the unexposed portions of the layer 106a. A hard bake can be performed after the developing operation.

In step 210 of Figure 2 and Figure 3D, an integrated circuit 114a is placed in opening 306 and mounted on the heat sink 104. The integrated circuit 114a may be configured in a variety of ways. For example, the integrated circuit 114a may be a bare or flip chip die, or it could have a BGA, LGA and/or other suitable pinout configuration. In the illustrated embodiment, the thickness of the integrated circuit 114a is greater than the thickness of the epoxy layer 106a in which it is initially embedded, although in other embodiments, the die may be substantially the same thickness, or thinner than the epoxy layer in which it is initially embedded. The active face of the integrated circuit 114a may face up or down. In particular embodiments, the integrated circuit 114a may be attached and thermally coupled to heat sink 104 using an adhesive.

After the integrated circuit 114a has been positioned in opening 306 and attached to the heat sink, a second layer of epoxy 106b is applied over the integrated circuit 114a and the epoxy layer 106a (step 204 of Figure 2) as illustrated in Figure 3E. Like the first epoxy layer 106a, the second epoxy layer 106b may be deposited using any suitable method, such as spin coating. In the illustrated embodiment, epoxy layer 106b is directly over, immediately adjacent to and/or in direct contact with integrated circuit 114a and epoxy layer 106a, although other arrangements are possible. The epoxy layer 106b may completely or partially cover the active surface of integrated circuit 114a.

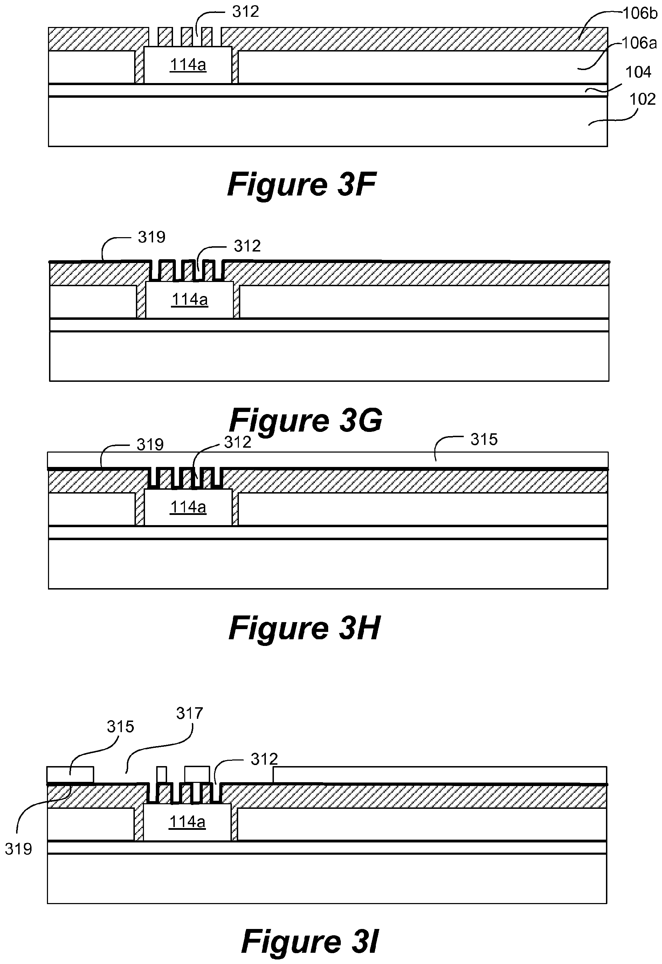

After epoxy layer 106b has been applied, it is patterned and developed using any suitable techniques (steps 206 and 208), which would typically be the same techniques used to pattern the first epoxy layer 106a. In the illustrated embodiment, via openings 312 are formed over integrated circuit 114a to expose I/O bond pads (not shown) on the active surface of integrated circuit 114a. The resulting structure is illustrated in Figure 3F.

After any appropriate via openings 312 have been formed, a seed layer 319 is deposited over openings 312 and epoxy layer 106b, as shown in Figure 3G. The seed layer 319 can be made of various suitable materials, including a stack of sequentially applied sublayers (e.g., Ti, Cu and Ti,) and can be be deposited using a variety of processes (e.g., by sputtering a thin metal layer on the exposed surfaces.) A feature of the described approach is that the sputtered seed layer tends to coat all exposed surfaces including the sidewalls and bottoms of via openings 312. The deposition of seed layer 319 can also be limited to just a portion of the exposed surfaces.

In Figure 3H, a photoresist 315 is applied over the seed layer 319. The photoresist 315, which can be positive or negative, covers seed layer 319 and fills openings 312. In Figure 3I, the photoresist is patterned and developed to form open regions 317 that expose the seed layer 319. The open areas are patterned to reflect the desired layout of the interconnect layer, including any desired conductive traces and heat pipes, and any vias desired in the underlying epoxy layer 106(b). After the desired open areas have been formed, the exposed portions of the seed layer are then electroplated to form the desired interconnect layer structures. In some embodiments, a portion of the seed layer (e.g., Ti) is etched prior to electroplating. During electroplating, a voltage is applied to seed layer 319 to facilitate the electroplating of a conductive material, such as copper, into the open regions 317. After the interconnect layer has been formed, the photoresist 315 and the seed layer 319 in the field is then stripped.

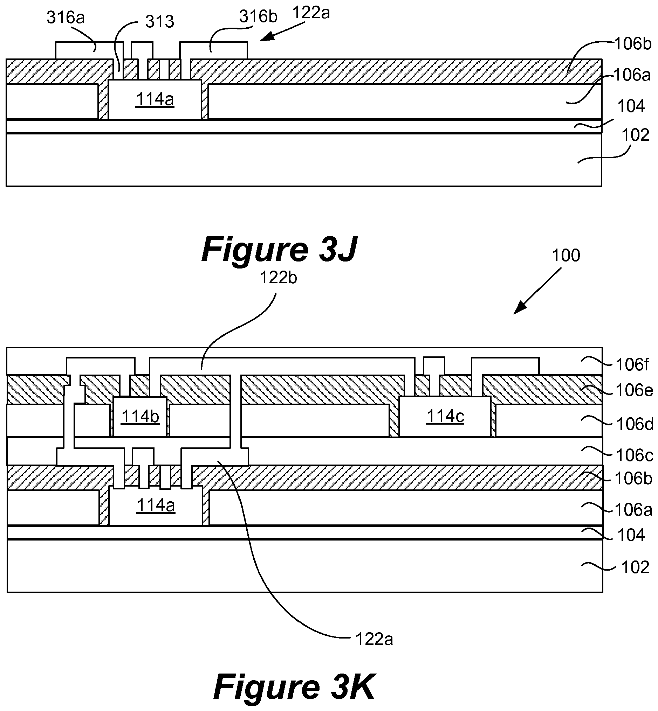

As a result, interconnect layer 122a is formed over the epoxy layer 106b, as illustrated in Figure 3J (step 212). The aforementioned electroplating served to fill the via opening with metal thereby forming metal vias 313 in the spaces formerly defined by the via openings. The metal vias 313 may be arranged to electrically couple the I/O pads of the integrated circuit 114a with corresponding traces 316 of interconnect layer 122a. Because seed layer 319 has been deposited on both the sidewalls and bottoms of openings 312, the conductive material accumulates substantially concurrently on the sidewalls and the bottoms, resulting in the faster filling of openings 312 than if the seed layer were coated only on the bottom of openings 312.

Although not shown in epoxy layers 106a and 106b, other vias can also be formed all the way through one or more epoxy layers to couple components (e.g. traces, passive devices, external contact pads, ICs, etc. together). In still other arrangements conductive vias may be formed between a surface of a bottom (or other) surface of an integrated circuit and the heat sink layer 104 to provide a good thermal conduction path to the heat sink even when the metallization is not used for its current carrying capabilities. In general, interconnect layer 122a can have any number of associated traces and metal vias and these conductors can be routed in any manner appropriate for electrically coupling their associated package components.

It is noted that a particular sputtering/electro-deposition process has been described that is well suited for forming traces over and vias within an associated epoxy layer 106 at substantially the same time. However, it should be appreciated that a variety of other conventional or newly developed processes may be used to form the vias and traces either separately or together.

After the interconnect layer 122a has been formed, steps 204, 206, 208, 210 and/or 212 can generally be repeated in any order that is appropriate to form additional epoxy layers, interconnect layers, and to place or form appropriate components therein or thereon to form a particular package 100 such as the package illustrated in Figure 3K. By way of example, in the illustrated embodiment additional epoxy layers 106c-106f are applied over layer 106b (effectively by repeating step 204 as appropriate). Integrated circuits 114b and 114c are embedded within epoxy layers 106d and 106e (steps 206, 208 and 210). Another interconnect layer 122b is formed within top epoxy layer 106f (steps 206, 208 and 212) and so on.

It should be appreciated that integrated circuits and interconnect layers in package 100 may be arranged in a variety of ways, depending on the needs of a particular application. For example, in the illustrated embodiment, the active faces of some integrated circuits are stacked directly over one another (e.g., integrated circuits 114a and 114b). Some integrated circuits are embedded within the same epoxy layer or layers (e.g., integrated circuits 114b and 114c.) Integrated circuits may be embedded in epoxy layers that are distinct from epoxy layers in which interconnect layers are embedded (e.g., interconnect layer 318a and electrical circuits 114a and 114b). ("Distinct" epoxy layers means layers where each layer is deposited in a single, cohesive coat in a sequence with the other layers, as is the case with epoxy layers 106a-106e.) Integrated circuits may be stacked over and/or situated in close proximity to one another. Integrated circuits may also be electrically coupled via electrical interconnect layers, vias and/or traces that extend substantially beyond the immediate vicinity or profile of any single integrated circuit (e.g., integrated circuits 114b and 114c).

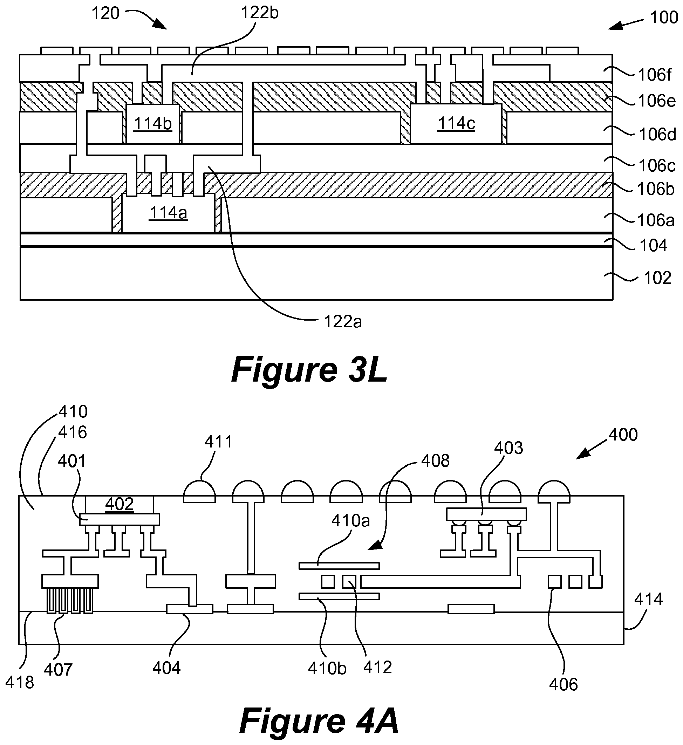

In step 214 of Figure 2 and Figure 3L, optional external contact pads 120 can be added to a top surface of package 100. The external contact pads 120 may be placed on other surfaces and formed in a variety of ways. For example, top epoxy layer 106f may be patterned and developed using the techniques described above to expose portions of electrical interconnect layer 122b. Any suitable metal, such as copper, may be electroplated into the holes on epoxy layer 106f to form conductive vias and external contact pads 120. As a result, at least some of the external contact pads 120 can be electrically coupled with electrical interconnect layers 122a-122b and/or integrated circuits 114a-114c.

The features of package 100 may be modified in a variety of ways. For example, it could contain more or fewer integrated circuits and/or interconnect layers. It could also contain multiple additional components, such as sensors, MEMS devices, resistors, capacitors, thin film battery structures, photovoltaic cells, RF wireless antennas and/or inductors. In some embodiments, substrate 102 is background away or otherwise discarded. Substrate 102 may have any suitable thickness. By way of example, thicknesses in the range of approximately 100 to 250 um work well for many applications. The thickness of the package 100 may vary widely. By way of example, thicknesses in the range of 0.5 to 1 mm work well in many applications. The thickness of electrical interconnect layers 122a and 122b may also widely vary with the needs of a particular application. By way of example, thicknesses of approximately 50 microns are believed to work well in many applications.

Figure 4A is a cross-sectional view of another embodiment of the present invention. Similar to package 100 of Figure 1, package 400 of Figure 4A includes integrated circuits 401 and 403, epoxy layers 410 and multiple interconnect layers. Package 400 also includes some additional optional features that are not shown in package 100.

For example, package 400 features an integrated circuit 401 that is thermally coupled with a heat sink 402. In the illustrated embodiment, some of the dimensions of heat sink 402 are substantially similar to those of the thermally coupled device. In particular embodiments, heat sink 402 may be larger or smaller than its underlying device. Heat sink 402 may be positioned on and/or be in direct contact with a top or bottom surface of the integrated circuit 401. It may have direct access to an external surface of package 400 (as is the case in the illustrated embodiment), or be connected to the external surface via one or more thermal vias. Heat sink 402 can be thermally coupled with a conductive layer, such as layer 104 of Figure 1. In a preferred embodiment in which the epoxy layers 410 are made of SU-8, having a heat sink 402 directly below integrated circuit 401 can be particularly helpful, since heat does not conduct well through SU-8.

Package 400 also features various passive components, such as inductors 406 and 408, resistor 404 and capacitor 407. These passive components may be situated in any epoxy layer or location within package 400. They may be formed using a variety of suitable techniques, depending on the needs of a particular application. For example, inductor windings 412 and inductor cores 410a and 410b can be formed by depositing conductive material and ferromagnetic material, respectively, over at least one of the epoxy layers 410. Thin-film resistors may be formed by sputtering or applying any suitable resistive material, such as silicon chromium, nickel chromium and/or silicon carbide chrome, over one of the epoxy layers 410. Capacitors can be formed by sandwiching a thin dielectric layer between metal plates deposited over one or more epoxy layers. Prefabricated resistors, inductors and capacitors may be placed on one or more epoxy layers 410 as well. Conductive, ferromagnetic and other materials can be deposited using any suitable method known in the art, such as electroplating or sputtering.

Package 400 also includes optional BGA-type contact pads 411 on frontside surface 416. Because of the location of the contact pads 411, substrate 414 can be made of various materials, such as G10-FR4, steel or glass. In particular embodiments where the contact pads are on the backside surface 418, the substrate 414 can be made of silicon and feature through vias that enable electrical connections with the contact pads. In another embodiment, the substrate is primarily used as a building platform to form the package 400 and is ultimately ground off.

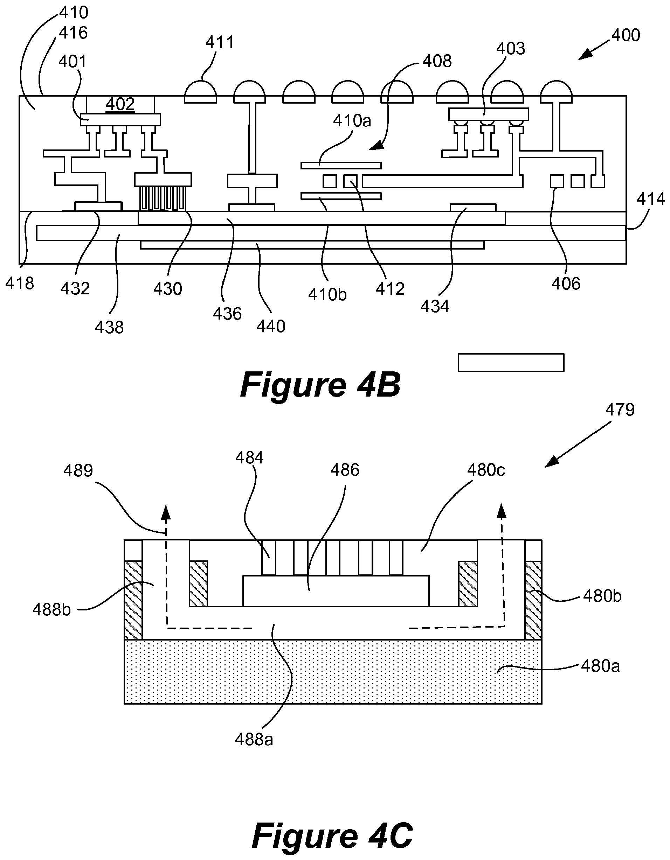

Figure 4B illustrates another embodiment of the present invention, which has many of the features illustrated in Figure 4A. This embodiment includes additional components, including precision trim-able capacitor 430 and resistor 432, micro-relay 434, low cost configurable, precision passive feedback network 436, FR-4 mount 438, and photovoltaic cell 440. Cell 440 could be covered with a layer of transparent material, such as transparent SU-8. In other embodiments, photovoltaic cell 440 could be replaced by a windowed gas sensor, a wireless phased antenna array, a heat sink or another suitable component. Package 400 can include many additional structures, including a power inductor array, a RF capable antenna, thermal pipes and external pads for dissipating heat from the interior of the package 100.

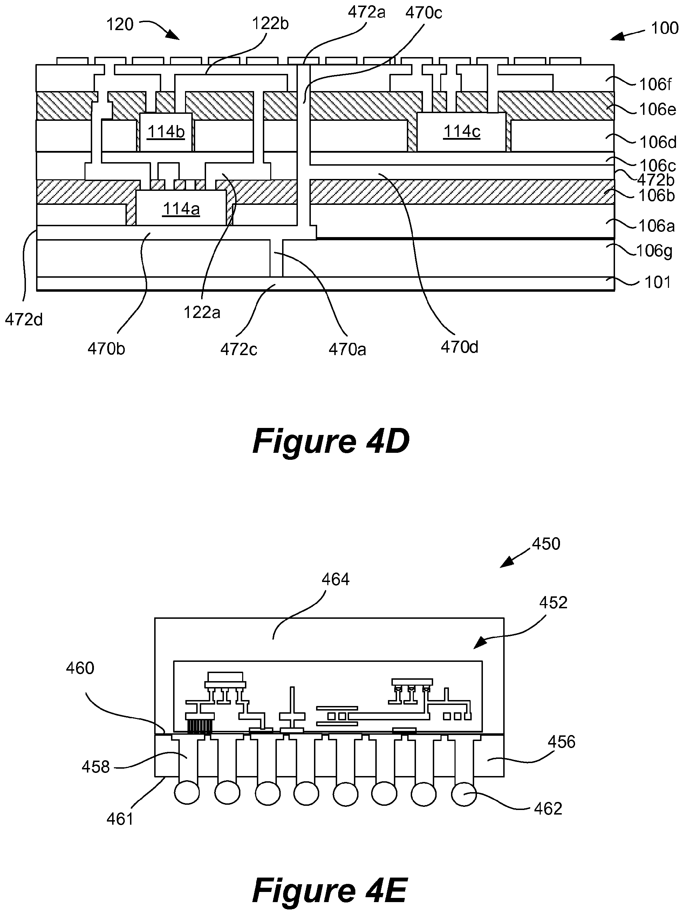

Figures 4C and 4D illustrate two other embodiments having thermal pipes. Figure 4B illustrates a package 479 that includes an integrated circuit 486 embedded in multiple layers of planarizing, photo-imageable epoxy 480. Metal interconnects 484 are coupled with bond pads (not shown) on the active surface of the integrated circuit 486. The backside of the integrated circuit 486 is mounted onto a thermal pipe 488, which includes thermal trace 488a and thermal vias 488b. Thermal pipe 488 is made of any suitable material that conducts heat well, such as copper. As indicated by the dotted line 489, heat from the integrated circuit 486 is routed through the backside of the integrated circuit 486, around thermal trace 488a and up through thermal vias 488b, so that the heat is ventilated through the external top surface of the package 479. The embodiment illustrated in Figure 4B can be fabricated using various techniques, such as the ones discussed in connection with Figures 3A-3K.

Figure 4D illustrates another embodiment of the present invention. The embodiment includes an integrated circuit 114a whose bottom surface is thermally coupled with thermal pipes 470. Thermal pipes 470 are made from a thermally conductive material, such as copper, and transmit heat from the integrated circuit 114a to external heat ventilation sites 472 of package 100. Heat dissipation can pose a problem for packages with multiple integrated devices and high power densities. Thermal pipes 470, which can be coupled with one or more devices within package 100, allow internally generated heat to be transported to one or more external surfaces of package 100. In Figure 4C, for example, heat is conducted away from the integrated circuit 114a to heat ventilation sites 472 on the top, bottom and multiple side surfaces of package 100, although heat ventilation sites can be located on almost any location on the exterior of the package 100.

Heat sinks can also be mounted on the top, bottom, side and/or almost any external surface of the package 100. In the illustrated embodiment, for example, heat spreader 101, which is on the bottom surface of package 100, is thermally coupled with thermal pipes 470 and dissipates heat over the entire bottom surface area of package 100. In one embodiment, all of the thermal pipes in the package 100, which are thermally coupled with multiple embedded integrated circuits, are also coupled with heat spreader 102. In a variation on this embodiment, some of the thermal pipes are also coupled with a heat sink located on the top surface of the package 100. Thermal pipes 470 can be formed using processes similar to those used to fabricate interconnect layers 122. They can be coupled with multiple passive and/or active devices within package 100 and can extend in almost any direction within package 100. In the illustrated embodiment, for example, thermal pipes 470 extend both parallel and perpendicular to some of the planes formed by the photo-imageable layers 106. As shown in Figure 4C, thermal pipes 470 can include thermal traces 470b and 470d and/or vias 470a and 470c that penetrate one or more interconnect layers 122 and/or photo-imageable layers 106. The thermal pipes 470 can be configured to dissipate heat, conduct electrical signals, or both. In one embodiment, an interconnect layer for transmitting electrical signals and a thermal pipe that is not suitable for transmitting electrical signals are embedded within the same epoxy layer.

Another embodiment of the present invention is illustrated in Figure 4E. Package arrangement 450 includes a microsystem 452 formed on the top surface 460 of substrate 456. Microsystem 452 may include multiple dielectric layers, interconnect layers, active and/or passive components and can have any of the features described in connection with package 100 of Figure 1 and/or package 400 of Figure 4A. Microsystem 452 and top surface 460 of substrate 465 are encapsulated in molding material 464, which may be made of any suitable material, such as a thermosetting plastic. Multiple metallic vias 458 electrically couple external pads (not shown) on the bottom of microsystem 452 with the bottom surface 461 of substrate 456. The vias 458 terminate at optional solder balls 462, which can be made from various conductive materials. Solder balls 462 may be mounted on, for example, a printed circuit board to enable electrical connections between microsystem 452 and various external components.

Figures 5A-5J illustrate cross-sectional views of a wafer level process for building a package similar to arrangement 450 of Figure 4D. Figure 5A depicts a wafer 500 with a top surface 502 and a bottom surface 504. Only a small portion of wafer 500 is shown. The dotted vertical lines indicate projected scribe lines 508. In the illustrated embodiment, substrate 500 can be made of a variety of suitable materials, such as silicon.

In Figure 5B, the top surface 502 of wafer 500 is etched to form holes 506. This etching process may be performed using a variety of techniques, such as plasma etching. Afterwards, metal is deposited into the holes to form an electrical system. This deposition may be performed using any suitable method, such as electroplating. For example, a seed layer (not shown) may be deposited over top surface 502 of wafer 500. The seed layer may then be electroplated with a metal such as copper. The electroplating process can produce metal vias 510 and contact pads 512 on the top surface 502 of wafer 500.

In Figure 5D, microsystems 513 are formed on the top surface 502 of wafer 500 using steps similar to those described in connection with Figures 2 and 3A-3L. In the illustrated embodiment, microsystems 513 do not have external contact pads formed on their top surfaces 515, as the top surfaces 515 will be overmolded in a later operation. In another embodiment, external contact pads are formed on top surfaces 515 to enable wafer level functional testing prior to overmolding. Microsystems 513 have external contact regions on their bottom surfaces 517, which are aligned with the contact pads 512 on the top surface 502 of wafer 500. This facilitates an electrical connection between the metal vias 510 and the interconnect layers within the microsystems 513.

In Figure 5E, a suitable molding material 520 is applied over the microsystems 513 and the top surface 502 of the wafer 500. The molding process can be performed using a variety of suitable techniques and materials. As a result, a molded wafer structure 522 is formed. In some designs, the molding material 520 completely covers and encapsulates microsystems 513 and/or the entire top surface 502. The application of molding material 520 may provide additional mechanical support for microsystems 513, which may be useful when microsystems 513 are large.

Figure 5F depicts molded wafer structure 522 after the bottom surface 504 of wafer 500 has been partially removed using any of a range of suitable techniques, such as backgrinding. As a result, portions of metal vias 510 are exposed. In Figure 5G, solder balls 524 are applied to the exposed portions of metal vias 510. In Figure 5H, the molded wafer structure 522 is then singulated along projected scribe lines 508 to create individual package arrangements 526. The singulation process can be performed using a variety of appropriate methods, such as sawing or laser cutting.

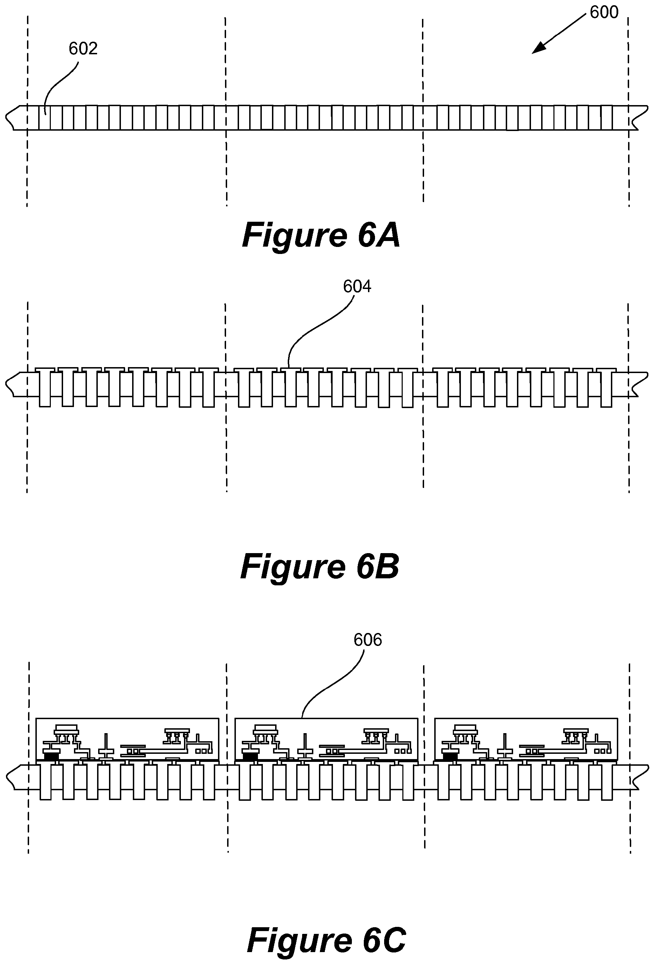

Figures 6A-6C illustrate cross-sectional views of a wafer level process for building a package according to another embodiment of the present invention. Figure 6A shows a substrate 600 prefabricated with through holes 602. Figure 6B illustrates the deposition of metal into the holes 602 to form metal vias 604. The deposition of metal can be performed using any suitable technique, such as electroplating. In some embodiments, the substrate 600 comes prefabricated with through holes 602 and/or metal vias 604, thus eliminating one or more processing steps. In Figure 6C, microsystems 606 are formed over the metal vias 604 and the substrate 600 using any of the aforementioned techniques. Afterward, solder bumping and singulation can be performed, as shown in Figures 5G and 5H. The illustrated embodiment can include various features like those described in connection with Figures 5A-5H.

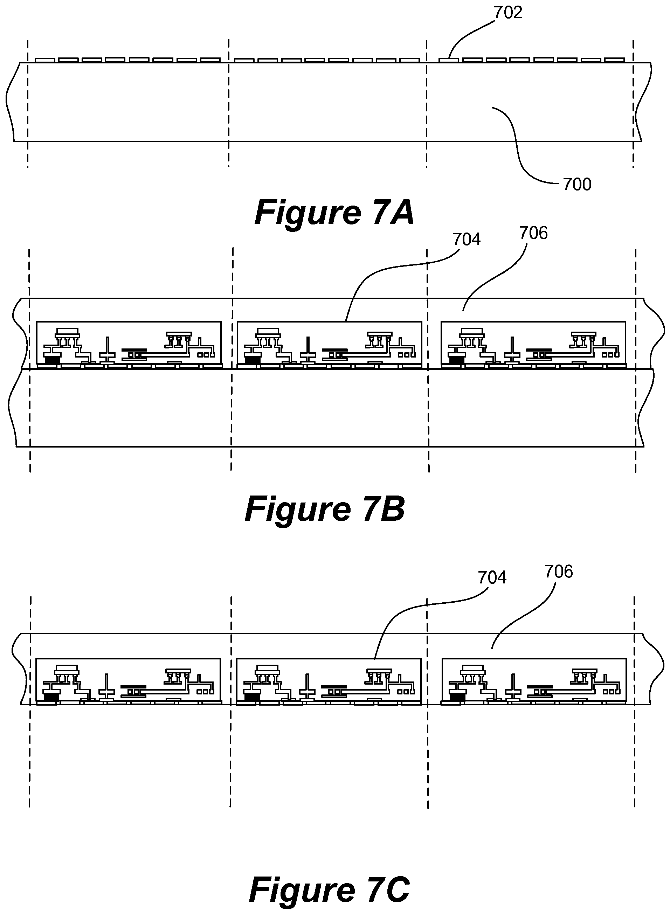

Figures 7A-7C illustrate cross-sectional views of a wafer level process for building a package according to another embodiment of the present invention. Initially, a substrate 700 is provided. Copper pads 702 are then formed over the top surface of the substrate 700. In Figure 7B, microsystems 704 are formed over copper pads 702 and substrate 700 using any of the aforementioned techniques. The microsystems 704 and the top surface of the substrate 700 are then encapsulated in a suitable molding material 706. The substrate 700 is then entirely ground away or otherwise removed in Figure 7C. Afterward, solder bumps can be attached to copper pads 702. The illustrated embodiment can include various features like those described in connection with Figures 5A-5H.

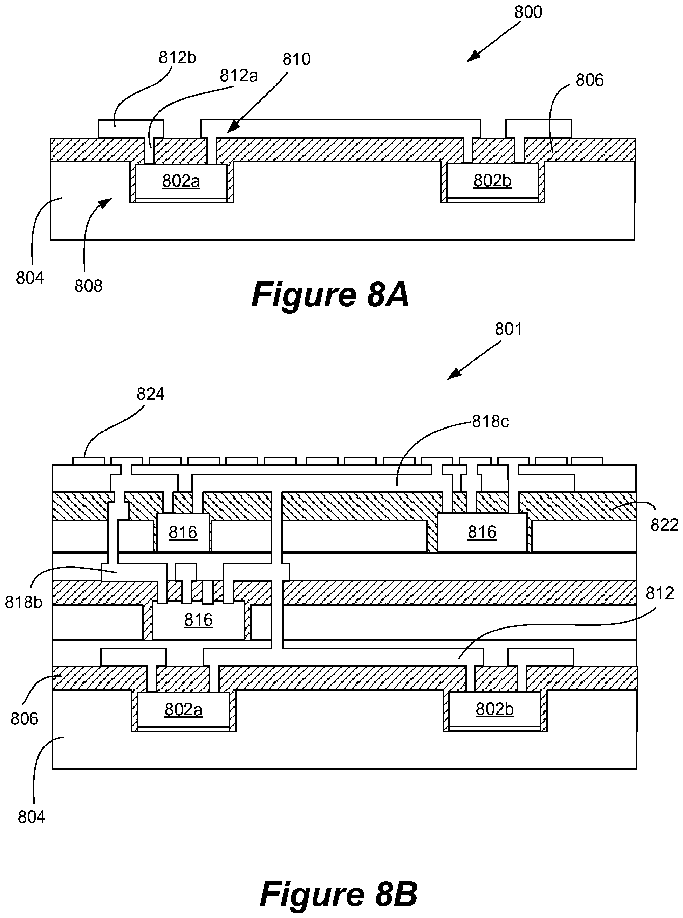

Additional embodiments of the present invention are illustrated in Figures 8-10. These embodiments pertain to integrated circuit packages in which one or more integrated circuits is embedded within a substrate e.g., a silicon substrate. The embedded integrated circuit is covered with a photo-imageable epoxy layer. An interconnect layer is formed over the epoxy layer and is electrically coupled with the integrated circuit through one or more vias in the epoxy layer.

Embedding one or more integrated circuits in the substrate can offer various advantages. For example, various embodiments of the present invention involve embedded integrated circuits that can use the substrate as a thermal heat sink, an electrically conductor, and/or a medium for optical communication. When a silicon wafer is used as the substrate, the similarity in the coefficients of thermal expansion of an embedded integrated circuit and a silicon substrate can help reduce the risk of delamination. In some implementations the embedding of an integrated circuit in the substrate instead of the epoxy layer can help minimize the thickness of the epoxy layer and reduce the size of the package.

Referring now to Figures 8A and 8B, various examples of integrated circuit packages that include substrates with one or more embedded integrated circuits are described. Figure 8A illustrates an integrated circuit package 800, which includes a substrate 804, integrated circuits 802, a layer of epoxy 806 and an interconnect layer 812. The substrate 804 is preferably a silicon wafer, which is easily handled by existing semiconductor packaging equipment. Depending on the intended use of the package 800, however, other suitable materials (e.g., glass, quartz, etc.) can be used. Integrated circuits 802 are positioned within cavities 808 in a top surface of the substrate 804. The active face of the integrated circuits 802 and the top surface of the substrate 804 are covered with a layer of epoxy 806. The epoxy layer 806 is made of a planarizing, photo-imageable, epoxy such as SU-8. The interconnect layer 812 is formed over the epoxy layer 806. The interconnect layer 812 includes conductive traces 812b and conductive vias 812a, which extend into openings 810 in the epoxy layer 806 and are electrically coupled with I/O pads on the active faces of the integrated circuits 802. In various implementations where the addition of more epoxy layers, integrated circuits and electrical components are not contemplated, a dielectric layer can be applied over the interconnect layer 812. Bonding pads can be formed on the outside of the package 800 that are electrically coupled with the integrated circuits 802 and the interconnect layer 812 through openings in the dielectric layer.

Figure 8B illustrates another embodiment of the present invention that involves positioning additional epoxy layers, integrated circuits and interconnect layers over the substrate 804. The integrated circuit package 801 includes multiple, adjacent layers of epoxy 822, interconnect layers 818 and integrated circuits 816 that are stacked over the interconnect layer 812, epoxy layer 806, integrated circuits 802 and substrate 804. Integrated circuits 816 are each positioned in at least one of the epoxy layers 822. Interconnect layers 818 are interspersed between various integrated circuits 816 and epoxy layers 822. The interconnect layers 818 electrically connect various integrated circuits 802 and 816 with one another and with I/O pads 824 that are formed on the top surface of the integrated circuit package 801.

It should be appreciated the Figures 8A and 8B represent particular embodiments from which many variations are possible. For example, there can be one or almost any number of integrated circuits positioned within or on the substrate 804. The positioning of the conductive vias and traces, the placement and dimensions of the cavities and/or the thickness of the interconnect layers and epoxy layers can differ from what is shown in the figures. Additionally, any of the features and arrangements described in connection with Figures 1 through 7C can be combined with or be used to modify almost any aspect of Figures 8A and 8B.

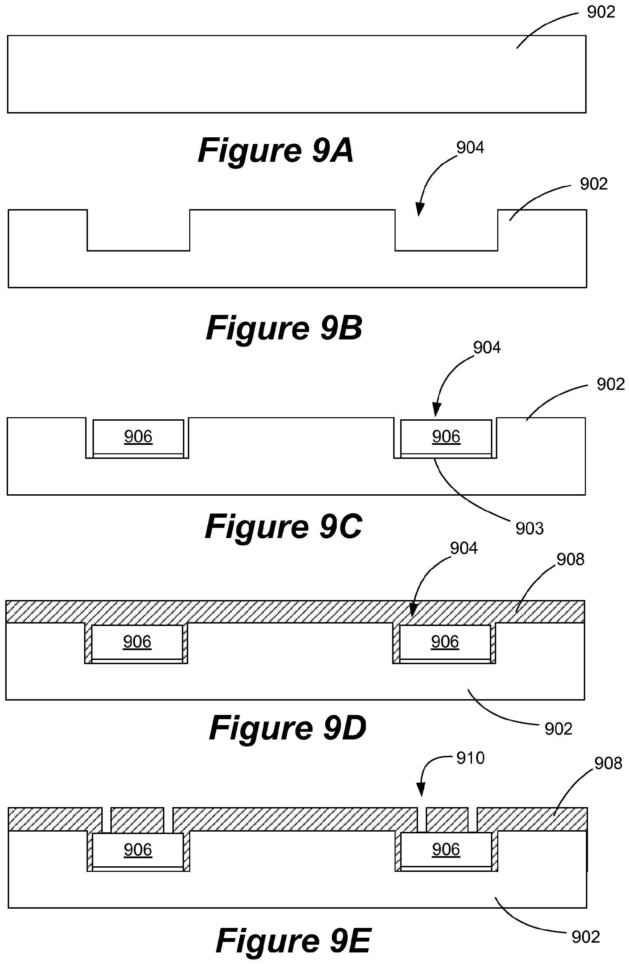

Referring to Figures 9A-9G, an exemplary method of forming the integrated circuit packages of Figures 8A and 8B is described. In Figure 9A, a substrate 902 is provided. In a preferred embodiment, the substrate 902 is a silicon wafer, as this can help maximize the compatibility of the operations of Figures 9A-9F with existing semiconductor wafer-based processing equipment. In alternative embodiments, substrate 902 can be made from a wide variety of materials, including silicon, glass, steel, G10-FR4, quartz, etc., depending on the needs of a particular application.

In Figure 9B, cavities 904 are formed in the substrate 902. Cavities 904 can be formed using wet or plasma etching, although other suitable techniques can be used as well. The chemistries used in the etching process and the crystalline structure of the silicon in the substrate 902 can help control the angle of the sidewalls for cavity 904. For example, it has been found that a silicon crystal structure of [1,1,0] can help produce a straighter sidewall and/or help form a sidewall that is approximately perpendicular to the bottom surface of its corresponding cavity. A die attach adhesive 903 can be applied to the bottom of the cavity 904 to help adhere the integrated circuit 906 to the bottom surface of the cavity 904, as shown in Figure 9C. In an alternative embodiment, the die attach adhesive 903 is applied to a back surface of the integrated circuit 906, either individually or on the wafer level, prior to the placement of the integrated circuit 906 in the cavity 904. Depending on the needs of a particular application, the die attach adhesive can be electrically conductive or non-conductive. In some embodiments, both types of adhesive are used in the same package such that one integrated circuit is electrically coupled through its bottom surface with an electrically conductive substrate and another integrated circuit is electrically insulated from the substrate. (Various applications for an electrically conductive substrate are discussed below.)

In Figure 9D, a layer of planarizing, photo-imageable epoxy 908 is deposited over the cavities 904, the substrate 902 and the integrated circuits 906. The epoxy layer 908 is preferably SU-8, but other suitable materials can also be used. The epoxy layer can extend over and come in direct contact with the active surface of the integrated circuit 906 and can fill in the cavity 904 in the substrate 902. As noted earlier, one of the advantages of using a photo-imageable epoxy such as SU-8 is the degree of control that can be exercised over it using photolithographic techniques.

In Figure 9E, one or more openings 910 are formed in the epoxy layer 908. The openings 910 can be created in a wide variety of ways known to persons of ordinary skill in the field of semiconductor processing. For example, the epoxy layer 908 can be photolithographically patterned and portions of the epoxy layer 908 can be dissolved using a developer solution. The openings 910 can expose I/O pads on the active surfaces of the integrated circuits 906 embedded within the epoxy layer 908.

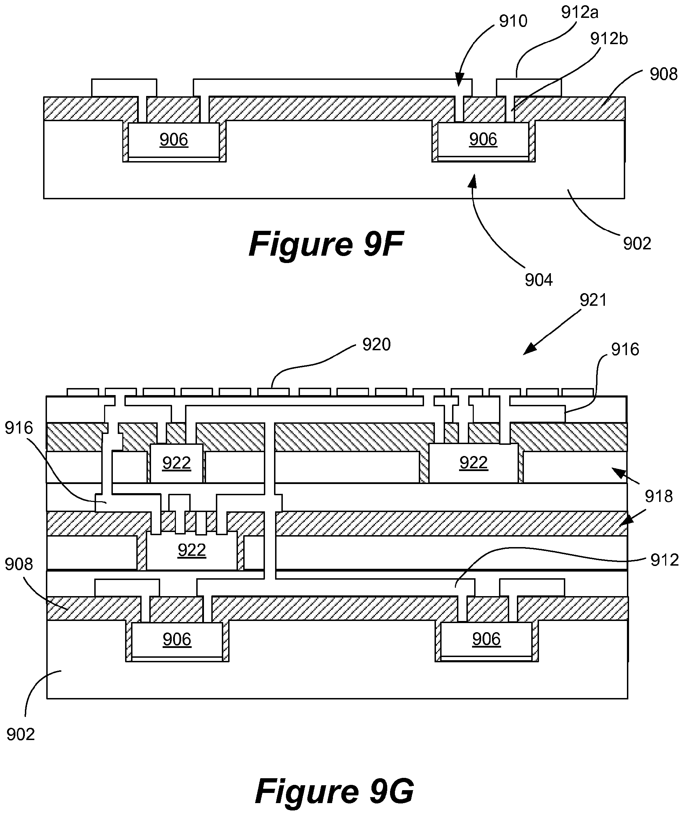

Figure 9F illustrates the formation of an interconnect layer 912, which can be performed using various suitable techniques that are known in the art. One approach, which can resemble the steps described in connection with Figures 3F-3J, involves depositing a seed layer and a photoresist layer, patterning the photoresist and electroplating a metal to form conductive traces 912a and conductive vias 912b in the openings 910. In various embodiments, the interconnect layer 912 electrically connects multiple integrated circuit dice 906 that are embedded in the substrate 902.

Afterward, additional epoxy layers 918, integrated circuits 922 and/or interconnect layers 916 can be formed over the substrate 902, integrated circuits 906, epoxy layer 908 and interconnect layer 912. These layers and components can be arranged in a wide variety of ways and any of the arrangements and features discussed in connection with Figures 1-7C can be used to modify any aspect of the illustrated embodiment. For example, the one or more interconnect layers 912 and/or 916 can be used to electrically connect the integrated circuits 906 positioned within the substrate 902 with any or all of the integrated circuits 922 that are embedded within the epoxy layers 918. Thermal pipes, which can be suitable or unsuitable for transmitting electrical signals, can extend from the substrate-based integrated circuit dice 906 to any exterior surface of the integrated circuit package 921. As described earlier, various passive and active devices, thermal pipes, heat sinks, sensors etc. can be formed or placed in almost any location of the integrated circuit package 921 (e.g., in the substrate 902, on the substrate 902, embedded between epoxy layers 918, etc.) The substrate 902 can also be subjected to backgrinding or any other operation suitable for reducing the thickness of the substrate 902. Figure 9G illustrates an example of the integrated circuit package of Figure 9F after additional epoxy layers, interconnect layers and integrated circuits have been applied over the substrate 902, integrated circuits 906, epoxy layer 908 and interconnect layer 912.

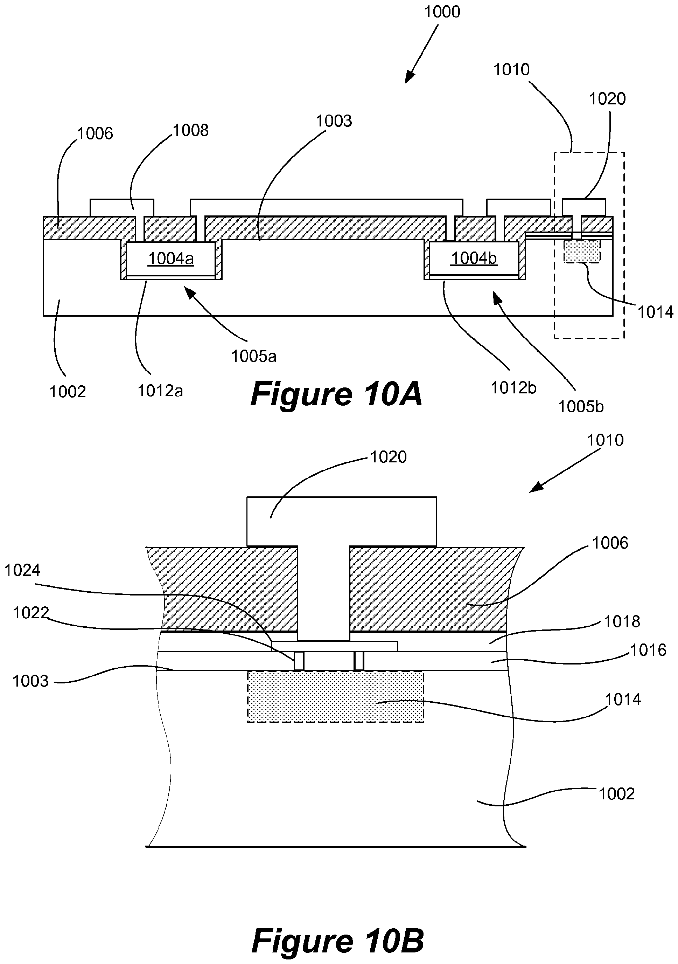

Additional embodiments of the present invention, each of which also include a substrate with one or more embedded integrated circuits, are illustrated in Figures 10A-10D. Figure 10A illustrates integrated circuit package 1000, which includes an electrically and thermally conductive substrate 1002 with embedded integrated circuits 1004, a planarizing, photo-imageable epoxy layer 1006 and an interconnect layer 1008. The integrated circuit package 100 can be formed using any of the techniques described in connection with Figures 9A-9F.

Integrated circuit 1004b is mounted onto a bottom surface of cavity 1005 in the substrate 1002 using an electrically conductive adhesive 1012b. As a result, integrated circuit 1004b is electrically coupled with the substrate 1002 and/or can use the substrate 1002 to dissipate heat to an exterior surface of the package. Some implementations also include an integrated circuit 1004a that is electrically insulated from the conductive substrate 1002 by a non-conductive adhesive 1012a. In the illustrated embodiment, only two integrated circuits are shown, but fewer or more integrated circuits that are each electrically coupled or insulated from the substrate 1002 can be positioned within the substrate 1002.

In various embodiments, the substrate 1002 can serve as a conduit for an electrical ground connection. Package 100 includes a ground interconnect 1020, which is formed over and extends through the epoxy layer 1006 and is electrically coupled with a ground contact region 1014 in the substrate 1002. Ground interconnect 1020 is made of an electrically conductive material, such as copper, and may have been formed at least partly during the formation of the interconnect layer 108, as described earlier in connection with Figure 9F.

Both the ground contact region 1014 in the substrate 1002 and other portions of the substrate 1002 are made of silicon and are doped to improve their electrical conductivity. In order to facilitate an electrical connection between substrate 1002 and the ground interconnect 1020, the ground contact region 1014 has a substantially higher doping concentration than one or more other portions of the substrate 1002. In various implementations the substrate 1002 is made of a p-type semiconductor material and the ground contact region 1014 is a p++ doping region, although the substrate 1002 and the ground contact region 1014 can be doped using any suitable materials and/or concentrations known by persons of ordinary skill in the art. As a result, when the ground interconnect 1020 is electrically grounded, the integrated circuit 1004b, the substrate 1002 and the ground contact region 1004 are electrically coupled with the ground interconnect 1020 and are likewise electrically grounded.

Figure 10B provides an enlarged view of region 1010 of Figure 10A according to one embodiment of the present invention. The figure includes substrate 1002 with ground contact region 1014, interlayer dielectric 1016, passivation layer 1018, electrically conductive plugs 1022, electrical interconnects 1024 and 1020, epoxy layer 1006 and ground interconnect 1020. Various techniques known to persons of ordinary skill in the field of semiconductor manufacturing can be used to deposit, pattern and/or develop interlayer dielectric 1016 and passivation layer 1018 and form plugs 1022 and electrical interconnect 1024. Plugs 1022 and electrical interconnect 1024 can be made from various suitable electrically conductive materials, including tungsten and aluminum respectively. Epoxy layer 1006 and interconnect 1020 can be formed using various techniques, including those described in connection with Figures 9D-9F.

The techniques used to form interlayer dielectric 116 and passivation layer 1018 of Figure 10B can be integrated into the techniques used to form cavities 1005 of Figure 10A. For example, prior to the formation of cavities 1005, interlayer dielectric 1016 can be deposited across the top surface 1003 of substrate 1002. The interlayer dielectric can be patterned and etched not only to create space for the plugs 1022, but also to form a mask for the formation of cavities 1005 in substrate 1002. Such an approach can help reduce the number of processing steps used to fabricate the integrated circuit package 1000.

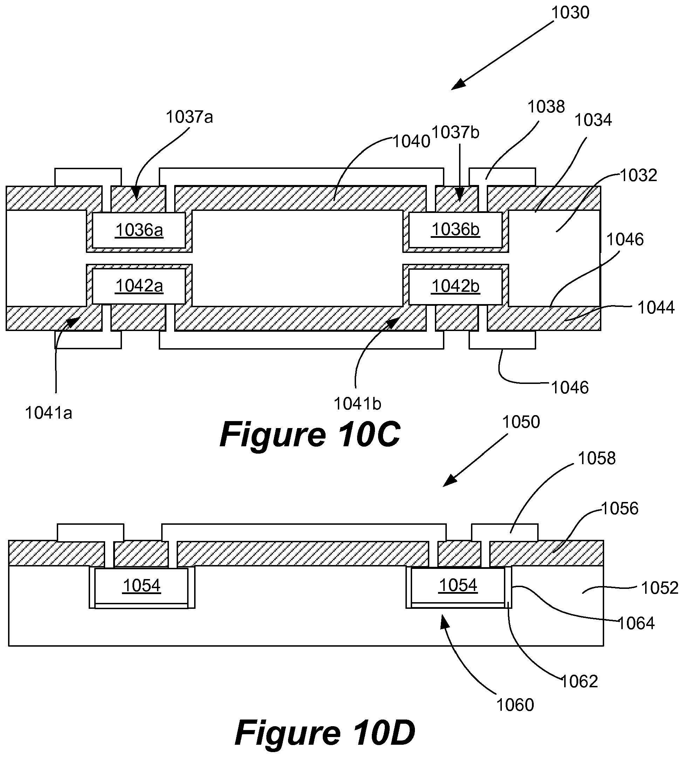

Another embodiment of the present invention is illustrated in Figure 10C. Figure 10C includes an integrated circuit package 1030 with integrated circuits, planarizing, photo-imageable epoxy layers and interconnect layers formed on opposing sides of a substrate. In the illustrated embodiment, integrated circuits 1036, epoxy layer 1040 and interconnect layer 1038 are formed over the top surface 1034 of substrate 1032. Integrated circuits 1042, epoxy layer 1044 and interconnect layer 1046 are formed over the opposing bottom surface 1046 of the substrate 1032. One approach to forming the integrated circuit package 1030 is to apply various techniques discussed in connection with Figures 9A-9F on both the top and bottom surfaces of the substrate 1032.

A particular implementation of the integrated circuit package 1030 involves arranging integrated circuits to communicate with one another optically through an optically transparent substrate. In the illustrated embodiment, for example, integrated circuits 1036a and 1042a are aligned over one another and include optical devices, such as a laser diode, optical detector, etc. (In still another embodiment, optical devices such as an optical sensor, optical detector, laser diode, etc. may be used in place of integrated circuits 1036a and/or 1042a.) At least the portion of the substrate 1034 between integrated circuits 1036a and 1042a is optically transparent and is arranged to allow optical communication between integrated circuits 1036a and 1042a. The optically transparent substrate can be made of various materials, including glass and quartz. Some implementations involve a substrate 1032 that is entirely made of a single optically transparent material and/or has a uniform composition.

Another approach involves a substrate 1032 made of silicon. The silicon substrate 1032 can electrically insulate the integrated circuits 1036a and 1042a but allow them to communicate optically using, for example, ultraviolet light, which is capable of traveling through silicon.

Still another embodiment of the present invention is illustrated in Figure 10D. Figure 10D shows an integrated circuit package 1050 with features for reducing stress on one or more integrated circuits 1054 embedded within the package substrate 1052. Integrated circuit package 1050 includes a substrate 1052 with cavities 1060, integrated circuits 1054, photo-imageable epoxy layer 1056 and interconnect layer 1058. Each cavity 1060 includes an air gap 1062 between a sidewall 1064 of the cavity 1060 and the integrated circuit 1054.

During testing and operation, the integrated circuit 1054 and package 1050 can be subjected to temperature cycling. Increases in temperature can cause the integrated circuit 1054 and other components of the package 1050 to expand. If the integrated circuit 1054 is encapsulated in a resilient material, such expansion can impose additional stress upon the integrated circuit 1054. The air gap 1062 can provide room for the integrated circuit 1054 to expand and thus help reduce such stress. Accordingly, epoxy layer 1056 covers but does not extend substantially into the cavity 1060.

Various approaches can be used to form the features of the integrated circuit package 1050. For example, the forming of cavities 1060 in the substrate 1052 and the placement of integrated circuits 1054 in the cavities 1060 can be performed as described earlier in connection with Figures 9A-9C. Afterward, a prefabricated sheet of photo-imageable epoxy, such as SU-8, can be applied such that it covers the cavities 1060 and the substrate 1052. In various embodiments, the epoxy layer 1056 is not spray- or spin-coated over the cavities 1060, but is instead laminated onto the substrate 1052. This approach helps to preserve air gaps 1062 between each integrated circuit 1054 and the sidewalls 1064 of the corresponding cavity 1060. The formation of openings in the epoxy layer 1056 and the interconnect layer 1058 can then proceed in a manner similar to the operations described in connection with Figures 9E-9F. For example, the epoxy layer 1056 can be patterned using photolithography, which can result in the curing and/or removal of portions of the epoxy layer 1056.

The present invention, however, contemplates a wide variety of integrated circuit packages that can each contain almost any combination of the features described herein and be formed using almost any combination of the processes described herein. To use an example, the substrate 804 of the integrated circuit package 800 of Figure 8A, which includes one or more embedded integrated circuits 802, can also include metal vias that penetrate through the substrate 804 and electrically connect the interconnect layer 812 with the contacts on the exterior surface of the substrate 804. Such metal vias are described in connection with Figure 4E. The processes for making the metal vias are described in connection with Figures 5A-5H and can be similarly applied to substrate 804 of Figure 8A.

## Claims

1. An integrated circuit package comprising:
a plurality of immediately adjacent stacked layers (106a - 106f) of cured, planarizing, photo-imageable epoxy;
at least one interconnect layer (122a), each interconnect layer being embedded in an associated epoxy layer and including a plurality of interconnect traces;
a plurality of I/O pads (120) exposed on a first surface of the package; and
a first integrated circuit (114a) positioned within at least one of the epoxy layers (106a - 106f) and having an active surface, wherein at least one of the epoxy layers extends over the active surface of the first integrated circuit and the first integrated circuit (114a) is electrically coupled to at least one associated I/O pad (120) at least in part through the at least one interconnect layer (122a); wherein the circuit comprises a substrate (102, 902) made of silicon that includes a top surface and an opposing bottom surface, there being a first cavity in the top surface of the substrate, the first integrated circuit (114a) positioned within the first cavity **characterised in that** one or more regions of the substrate are doped at a first doping concentration such that the substrate is electrically and thermally conductive, thereby helping the first integrated circuit (114a) to transmit heat to an exterior surface of the integrated circuit package.

2. The package of claim 1 comprising a plurality of passive devices including one of a group consisting of: a capacitor, a resistor, a MEMS device, a sensor, a thin film battery structure, a RF wireless antenna, a supercharger, an integrated photovoltaic switch and an inductor.

3. The package of any of the preceding claims wherein the plurality of immediately adjacent stacked layers (106a - 106f) are formed from SU-8.

4. The package of any of the preceding claims comprising at least one thermal pipe (488) embedded within at least one of the epoxy layers (106a - 106f), the at least one thermal pipe (488) thermally coupling the first integrated circuit (114a) with an external surface of the package, thereby conducting heat from the first integrated circuit to the exterior of the package.

5. The package of any of the preceding claims wherein the package is formed on a substrate, the substrate including a plurality of conductive vias (313) and a sensor component, the sensor component and ones of the at least one interconnect layer being electrically coupled via ones of the plurality of conductive vias (313) and wherein the sensor component is at least one of a group consisting of: a photovoltaic cell, a biosensor, a gas sensor, an acceleration sensor, a vibration sensor, a chemical sensor, an electromagnetic sensor, a temperature sensor and a humidity sensor.

6. The integrated circuit package of claim 1 wherein:
the substrate (102; 902; 1002) includes a ground contact region (1014) having a second doping concentration substantially greater than the first doping concentration, the ground contact region positioned at the top surface of the substrate (102; 902; 1002);
the integrated circuit package further comprises a ground interconnect (1020) formed from an electrically conductive material, the ground interconnect (1020) extending entirely through the first epoxy layer and being electrically connected to the ground contact region (1014) in the substrate; and
the first integrated circuit (906; 114a; 1004) includes a ground contact that is electrically coupled with the one or more doped regions of the substrate, wherein the ground interconnect (1020), the ground contact region (1014) of the substrate, the ground contact on the first integrated circuit and the one or more doped regions of the substrate are arranged to be electrically grounded and electrically coupled to one another.

7. The integrated circuit package of claim 1 or claim 6 wherein the substrate is made at least partly of an optically transparent material and wherein the first integrated circuit includes a first optical device, the integrated circuit package further comprising:
a second cavity in the bottom surface of the substrate; and
a second integrated circuit positioned in the second cavity, the second integrated circuit positioned opposite the first integrated circuit and including a second optical device arranged to optically communicate with the first optical device in the first integrated circuit through an optically transparent portion of the substrate.

8. The integrated circuit package of any of claims 1, 6 wherein there is an air gap between the sidewalls of the first cavity and the first integrated circuit positioned within the first cavity, thereby giving the first integrated circuit room to expand within the first cavity.

9. A packaging arrangement comprising:
a substrate (102) having a first surface and an opposing second surface, wherein ones of a plurality of metal vias (313) penetrates entirely through the substrate and terminate at ones of a plurality of external contact pads on the second surface of the substrate;
the package of any of the preceding claims formed on the first surface of the substrate (902, 102), ones of the plurality of I/O pads (120) aligning with ones of the plurality of metal vias (313), such that the at least one interconnect layer of the package is electrically coupled with at least one of the plurality of external contact pads (120) of the substrate; and
a molding material (464) that covers the first surface of the substrate and encapsulates the package.

10. A method for packaging integrated circuits, the method comprising:
sequentially depositing layers of epoxy over a substrate to form a multiplicity of planarized layers of epoxy over the substrate, wherein the epoxy layers are deposited by spin coating, there being a topmost epoxy layer;
photolithographically patterning at least some of the epoxy layers after they are deposited and before the next epoxy layer is deposited;
forming openings in at least some of the patterned epoxy layers after they are patterned and before the next epoxy layer is deposited;
placing a first integrated circuit within an associated one of the openings, wherein the first integrated circuit has a plurality of I/O bond pads and at least one of the epoxy layers is deposited after the placement of the first integrated circuit to thereby cover the first integrated circuit;
forming at least one conductive interconnect layer, wherein each interconnect layer is formed over an associated epoxy layer;
forming a multiplicity of external package contacts, wherein the first integrated circuit is electrically connected to a plurality of the external package contacts at least in part through at least one of the conductive interconnect layers; and
forming a first cavity in the top surface of the substrate and positioning the first integrated circuit positioned within the first cavity;
wherein the substrate is made of silicon and includes a top surface and an opposing bottom surface, wherein one or more regions of the substrate are doped at a first doping concentration such that the substrate is electrically and thermally conductive, thereby helping the first integrated circuit to transmit heat to an exterior surface of the integrated circuit package.

11. The method of claim 10 comprising:
forming openings in a first layer of the deposited layers of epoxy;
covering the first layer of the deposited layers of epoxy with a seed layer, such that the seed layer at least substantially covers bottoms and sidewalls of the openings in the first layer and a field of the first layer;
depositing a photoresist layer over the seed layer;
photolithographically patterning the deposited photoresist layer;
removing portions of the photoresist layer, thereby exposing portions of the seed layer; and
electroplating a conductive material onto the exposed portions of the seed layer, such that the conductive material accumulates substantially concurrently on the field of the first layer, the bottoms and the sidewalls of the openings in the first layer, thereby forming an interconnect layer having at least one conductive trace and at least one conductive via.

12. The method of claim 10 or 11 further comprising forming at least one thermal pipe, wherein each thermal pipe is formed over an associated epoxy layer and thermally couples the integrated circuit with at least one exterior surface of the package and wherein the formation of one of the at least one interconnect layer is performed at substantially the same time as the formation of one of the at least one thermal pipe.

13. A wafer level method for forming an integrated circuit package comprising:
providing a substrate having a first and an opposing second surface, the substrate having metal vias that extend between the first and second surfaces of the substrate;
forming a plurality of microsystems on the first surface of the substrate by performing the method of claim 10 or 11, each microsystem including:
the multiplicity of planarized epoxy layers;
the at least one interconnect layer, each interconnect layer embedded in an associated epoxy layer; and
the first integrated circuit positioned within at least an associated epoxy layer;
forming the interconnect layers of the plurality of microsystems such that ones of the interconnect layers are electrically coupled with ones of the metal vias;
applying molding material over the first surface of the substrate to form a molded structure, thereby encapsulating each one of the plurality of microsystems; and
singulating the molded structure to form individual integrated circuit packages, wherein each integrated circuit package includes at least one of the microsystems.

14. The method of claim 13 wherein the providing of the substrate comprises:
etching the second surface of the substrate to form the cavity in the substrate;
forming a sensing element within the cavity wherein the sensing element is one of a group consisting of: a photovoltaic cell, a biosensor, a gas sensor, a chemical sensor, an electromagnetic sensor, an acceleration sensor, a vibration sensor, a humidity sensor, and a wireless phased antenna;
removing portions of the substrate to form holes in the substrate; and
electroplating conductive material into the substrate to form the metal vias, wherein at least some of the metal vias are electrically coupled with the sensing element.

15. A method of forming an integrated circuit package:
providing a substrate having a first and an opposing second surface;
applying a conductive material on the first surface of the substrate to form substrate bond pads;
forming a plurality of microsystems on the first surface of the substrate by performing the method of claim 10 or 11, each microsystem including:
the multiplicity of planarized epoxy layers;
the at least one interconnect layer, each interconnect layer embedded in an associated epoxy layer; and
the first integrated circuit positioned within at least an associated epoxy layer;
forming the interconnect layers of the plurality of microsystems such that ones of the interconnect layers are electrically coupled with ones of the substrate bond pads;
applying molding material over the first surface of the substrate to form a molded wafer structure, thereby encapsulating each one of the plurality of microsystems;
singulating the molded wafer structure to form individual integrated circuit packages, wherein each integrated circuit package includes at least one of the plurality of microsystems; and
removing at least some of the substrate to expose the substrate bond pads.

16. A wafer level method for packaging integrated circuits, the method comprising:
performing the method of claim 10 or 11; forming a first passive component within at least one of the multiplicity of epoxy layers, wherein the first passive component is electrically coupled with the integrated circuit via at least one of the interconnect layers.

17. The method of claim 16 wherein the first passive component is a thin film resistor and the formation of the first passive component is performed by sputtering a conductive metal over at least one of the epoxy layers to form the thin film resistor.

18. The method of claim 16 or 17 wherein the first passive component is a capacitor and the formation of the first passive component includes forming metal layers and a dielectric layer such that the dielectric layer is sandwiched between the first and second metal layers.

19. The method of any of claims 16, 17 and 18 wherein the first passive component is a magnetic core and the formation of the first passive component includes sputtering a ferromagnetic material on at least one of the epoxy layers to form the magnetic core.

## Patentansprüche

1. Integriertes Schaltungs-Package, umfassend:
eine Vielzahl von unmittelbar benachbarten gestapelten Schichten (106a - 106f) aus gehärteten planarisierten fotobildfähigem Epoxy;
mindestens eine Zwischenverbindungsschicht (122a), wobei jede Zwischenverbindungsschicht in eine zugehörige Epoxyschicht eingebettet ist und eine Vielzahl von Zwischenverbindungsspuren einschließt;
eine Vielzahl von I/O-Kontaktflächen (120), die auf einer ersten Oberfläche des Packages freiliegen; und
eine erste integrierte Schaltung (114a), die innerhalb mindestens einer der Epoxyschichten (106a - 106f) positioniert ist und eine aktive Oberfläche aufweist, wobei mindestens eine der Epoxyschichten sich über die aktive Oberfläche der ersten integrierten Schaltung erstreckt und die erste integrierte Schaltung (114a) mindestens teilweise über die mindestens eine Zwischenverbindungsschicht (122a) elektrisch an mindestens eine zugehörige I/O-Kontaktfläche (120) gekoppelt ist;
wobei die Schaltung ein Substrat (102, 902) umfasst, das aus Silicium gefertigt ist, welches eine Deckfläche und eine gegenüberliegende Bodenfläche einschließt, wobei sich in der Deckfläche des Substrats ein erster Hohlraum befindet, wobei die erste integrierte Schaltung (114a) innerhalb des ersten Hohlraums positioniert ist, **dadurch gekennzeichnet, dass** eine oder mehrere Regionen des Substrats mit einer ersten Dotierkonzentration dotiert sind, so dass das Substrat elektrisch leitend und wärmeleitend ist, wodurch die erste integrierte Schaltung (114a) darin unterstützt wird, Wärme an eine Außenfläche des integrierten Schaltungs-Packages zu übertragen.

2. Package nach Anspruch 1, umfassend eine Vielzahl passiver Vorrichtungen, einschließlich einer aus einer Gruppe bestehend aus einem Kondensator, einem Widerstand, einer MEMS-Vorrichtung, einem Sensor, einer Dünnfilmbatteriestruktur, einer HF-Drahtlosantenne, einem Lader, einem integrierten Photovoltaikschalter und einem Induktor.

3. Package nach einem der vorhergehenden Ansprüche, wobei die Vielzahl der unmittelbar benachbarten gestapelten Schichten (106a - 106f) aus SU-8 gebildet ist.

4. Package nach einem der vorhergehenden Ansprüche, umfassend mindestens ein Wärmerohr (488), das in mindestens eine der Epoxyschichten (106a - 106f) eingebettet ist, wobei das mindestens eine Wärmerohr (488) die erste integrierte Schaltung (114a) mit der Außenfläche des Packages thermisch koppelt, wodurch Wärme von der ersten integrierten Schaltung an die Außenseite des Packages geleitet wird.

5. Package nach einem der vorhergehenden Ansprüche, wobei das Package auf einem Substrat gebildet ist, wobei das Substrat eine Vielzahl von leitenden Durchkontaktierungen (313) und eine Sensorkomponente einschließt, wobei die Sensorkomponente und eine der mindestens einen Zwischenverbindungsschicht elektrisch über eine der Vielzahl von leitenden Durchkontaktierungen (313) gekoppelt sind, und wobei die Sensorkomponente mindestens eine aus einer Gruppe bestehend aus einer Photovoltaikzelle, einem Biosensor, einem Gassensor, einem Beschleunigungssensor, einem Vibrationssensor, einem Chemikaliensensor, einem elektromagnetischen Sensor, einem Temperatursensor und einem Feuchtigkeitssensor ist.

6. Integriertes Schaltungs-Package nach Anspruch 1, wobei:
das Substrat (102; 902; 1002) eine Erdkontaktregion (1014) mit einer zweiten Dotierkonzentration einschließt, die im Wesentlichen größer als die erste Dotierkonzentration ist, wobei die Erdkontaktregion an der Deckfläche des Substrats (102; 902; 1002) positioniert ist;
das integrierte Schaltungs-Package ferner eine Erdzwischenverbindung (1020) umfasst, die aus einem elektrisch leitenden Material gebildet ist, wobei sich die Erdzwischenverbindung (1020) vollständig durch die erste Epoxyschicht erstreckt und elektrisch mit der Erdkontaktregion (1014) in dem Substrat verbunden ist; und
die erste integrierte Schaltung (906; 114a; 1004) einen Erdkontakt einschließt, der elektrisch an die eine oder mehreren dotierten Regionen des Substrats gekoppelt ist, wobei die Erdzwischenverbindung (1020), die Erdkontaktregion (1014) des Substrats, der Erdkontakt auf der ersten integrierten Schaltung und die einen oder mehreren dotierten Regionen des Substrats so angeordnet sind, dass sie elektrisch geerdet und elektrisch aneinander gekoppelt sind.

7. Integriertes Schaltungs-Package nach Anspruch 1 oder Anspruch 6, wobei das Substrat mindestens teilweise aus einem optisch transparenten Material gefertigt ist, und wobei die erste integrierte Schaltung eine erste optische Vorrichtung einschließt, wobei das integrierte Schaltungs-Package ferner umfasst:
einen zweiten Hohlraum in der Bodenfläche des Substrats; und
eine zweite integrierte Schaltung, die in dem zweiten Hohlraum positioniert ist, wobei die zweite integrierte Schaltung gegenüber der ersten integrierten Schaltung positioniert ist und eine zweite optische Vorrichtung einschließt, die vorgesehen ist, um mit der ersten optischen Vorrichtung in der ersten integrierten Schaltung über einen optisch transparenten Abschnitt des Substrats optisch zu kommunizieren.

8. Integriertes Schaltungs-Package nach einem der Ansprüche 1, 6, wobei ein Luftspalt zwischen den Seitenwänden des ersten Hohlraums ist und die erste integrierte Schaltung innerhalb des ersten Hohlraums positioniert ist, wodurch der ersten integrierten Schaltung Raum gegeben wird, innerhalb des ersten Hohlraums zu expandieren.

9. Packaging-Anordnung, umfassend:
ein Substrat (102) mit einer ersten Oberfläche und einer gegenüberliegenden zweiten Oberfläche, wobei eine von einer Vielzahl von Metalldurchkontaktierungen (313) das Substrat vollständig durchdringt und an einem von einer Vielzahl externer Kontaktflächen auf der zweiten Oberfläche des Substrats endet;
das Package nach einem der vorhergehenden Ansprüche, welches auf der ersten Oberfläche des Substrats (902, 102) gebildet ist, wobei eine von der Vielzahl der I/O-Kontaktflächen (120) mit einer von der Vielzahl der Metalldurchkontaktierungen (313) ausgerichtet ist, so dass die mindestens eine Zwischenverbindungsschicht des Packages elektrisch mit mindestens einer von der Vielzahl externer Kontaktflächen (120) des Substrats gekoppelt ist; und
ein Formungsmaterial (464), welches die erste Oberfläche des Substrats bedeckt und das Package verkapselt.

10. Verfahren zum Packaging integrierter Schaltungen, wobei das Verfahren umfasst:
aufeinander folgendes Absetzen von Epoxyschichten über einem Substrat zur Bildung einer Mehrzahl von planarisierten Epoxyschichten über dem Substrat, wobei die Epoxyschichten durch Rotationsbeschichten abgesetzt werden, wobei eine oberste Epoxyschicht vorhanden ist;
photolithografisches Strukturieren von mindestens einigen der Epoxyschichten, nachdem sie abgesetzt worden sind und bevor die nächste Epoxyschicht abgesetzt wird;
Bilden von Öffnungen in mindestens einigen der strukturierten Epoxyschichten, nachdem sie strukturiert worden sind und bevor die nächste Epoxyschicht abgesetzt wird;
Platzieren einer ersten integrierten Schaltung innerhalb eines zugehörigen der Löcher, wobei die erste integrierte Schaltung eine Vielzahl von I/O-Bondingflächen aufweist und mindestens eine der Epoxyschichten nach der Platzierung der ersten integrierten Schaltung abgesetzt wird, um dadurch die erste integrierte Schaltung zu bedecken;
Bilden mindestens einer leitenden Zwischenverbindungsschicht, wobei jede Zwischenverbindungsschicht über einer zugehörigen Epoxyschicht gebildet wird;
Bilden einer Mehrzahl von externen Package-Kontakten, wobei die erste integrierte Schaltung elektrisch mit einer Vielzahl der externen Package-Kontakte mindestens teilweise durch mindestens eine der leitenden Zwischenverbindungsschichten verbunden ist; und
Bilden eines ersten Hohlraums in der Deckfläche des Substrats und Positionieren der ersten integrierten Schaltung, die innerhalb des ersten Hohlraums positioniert wird;
wobei das Substrat aus Silicium gefertigt ist und eine Deckfläche und eine gegenüber liegende Bodenfläche einschließt, wobei eine oder mehrere Regionen des Substrats mit einer ersten Dotierkonzentration so dotiert ist bzw. sind, dass das Substrat elektrisch leitend und wärmeleitend ist, wodurch die erste integrierte Schaltung darin unterstützt wird, Wärme auf eine Außenfläche des integrierten Schaltbauteils zu übertragen.

11. Verfahren nach Anspruch 10, umfassend:
Bilden von Öffnungen in einer ersten Schicht der abgesetzten Epoxyschichten;
Bedecken der ersten Schicht der abgesetzten Epoxyschichten mit einer Impfschicht, so dass die Impfschicht mindestens im Wesentlichen Böden und Seitenwände der Öffnungen in der ersten Schicht und ein Feld der ersten Schicht bedeckt;
Absetzen einer Photoresistschicht über der Impfschicht;
photolithographisches Strukturieren der abgesetzten Photoresistschicht;
Entfernen von Abschnitten der Photoresistschicht, wodurch Abschnitte der Impfschicht freigelegt werden; und
Elektroplattieren eines leitenden Materials auf die freiliegenden Abschnitte der Impfschicht, so dass das leitende Material sich im Wesentlichen gleichzeitig auf dem Feld der ersten Schicht, den Böden und den Seitenwänden der Öffnungen in der ersten Schicht ansammelt, wodurch eine Zwischenverbindungsschicht mit mindestens einer leitenden Spur und mindestens einer leitenden Durchkontaktierung gebildet wird.

12. Verfahren nach Anspruch 10 oder 11, ferner umfassend Bilden mindestens eines Wärmerohrs, wobei jedes Wärmerohr über einer zugehörigen Epoxyschicht gebildet wird und die integrierte Schaltung thermisch mit mindestens einer Außenfläche des Packages koppelt, und wobei die Bildung von einer der mindestens einen Zwischenverbindungsschicht im Wesentlichen zur gleichen Zeit wie die Bildung von einem des mindestens einen Wärmerohrs durchgeführt wird.

13. Wafer-Level-Verfahren zur Bildung eines integrierten Schaltungs-Packages, umfassend:
Bereitstellen eines Substrats mit einer ersten und einer gegenüberliegenden zweiten Oberfläche, wobei das Substrat Metalldurchkontaktierungen aufweist, die sich zwischen der ersten und der zweiten Oberfläche des Substrats erstrecken;
Bilden einer Vielzahl von Mikrosystemen auf der ersten Oberfläche des Substrats durch Durchführen des Verfahrens nach Anspruch 10 oder 11, wobei jedes Mikrosystem einschließt:
die Mehrzahl von planarisierten Epoxyschichten;
die mindestens eine Zwischenverbindungsschicht, wobei jede Zwischenverbindungsschicht in eine zugehörige Epoxyschicht eingebettet ist; und
die erste integrierte Schaltung, die innerhalb mindestens einer zugehörigen Epoxyschicht positioniert ist;
Bilden der Zwischenverbindungsschichten von der Vielzahl der Mikrosystems so, dass eine der Zwischenverbindungsschichten elektrisch an eine der Metalldurchkontaktierungen gekoppelt ist;
Aufbringen von Formungsmaterial über die erste Oberfläche des Substrats, um eine geformte Struktur zu bilden, wodurch jedes einzelne der Vielzahl von Mikrosystemen verkapselt wird; und
Vereinzeln der geformten Struktur zur Bildung individueller integrierter Schaltungs-Packages, wobei jedes integrierte Schaltungs-Package mindestens eines der Mikrosysteme einschließt.

14. Verfahren nach Anspruch 13, wobei das Bereitstellen des Substrats umfasst:
Ätzen der zweiten Oberfläche des Substrats, um den Hohlraum in dem Substrat zu bilden;
Bilden eines Abfühlelements in dem Hohlraum, wobei das Abfühlelement eines von einer Gruppe bestehend aus einer Photovoltaikzelle, einem Biosensor, einem Gassensor, einem Chemikaliensensor, einem elektromagnetischen Sensor, einem Beschleunigungssensor, einem Vibrationssensor, einem Feuchtigkeitssensor und einer drahtlosen phasengesteuerten Antenne ist;
Entfernen von Abschnitten des Substrats, um Löcher in dem Substrat zu bilden; und
Elektroplattieren von leitendem Material in das Substrat, um die Metalldurchkontaktierungen zu bilden, wobei mindestens einige der Metalldurchkontaktierungen elektrisch an das Abfühlelement gekoppelt sind.

15. Verfahren zum Bilden eines integrierten Schaltungs-Packages:
Bereitstellen eines Substrats mit einer ersten und einer gegenüber befindlichen zweiten Oberfläche;
Aufbringen eines leitenden Materials auf die erste Oberfläche des Substrats, um Substratkontaktflächen zu bilden;
Bilden einer Vielzahl von Mikrosystemen auf der ersten Oberfläche des Substrats durch Durchführen des Verfahrens nach Anspruch 10 oder 11, wobei jedes Mikrosystem einschließt:
die Mehrzahl von planarisierten Epoxyschichten;
mindestens eine Zwischenverbindungsschicht, wobei jede Zwischenverbindungsschicht in eine zugehörige Epoxyschicht eingebettet ist; und
die erste integrierte Schaltung, die innerhalb mindestens einer zugehörigen Epoxyschicht positioniert ist;
Bilden der Zwischenverbindungsschichten von der Vielzahl der Mikrosystems so, dass eine der Zwischenverbindungsschichten elektrisch an eine der Substratkontaktflächen gekoppelt ist;
Aufbringen von Formungsmaterial über der ersten Oberfläche des Substrats, um eine geformte Struktur zu bilden, wodurch jedes einzelne der Vielzahl von Mikrosystemen verkapselt wird;
Vereinzeln der geformten Wafer-Struktur zur Bildung individueller integrierter Schaltungs-Packages, wobei jedes integrierte Schaltungs-Package mindestens eines der Vielzahl von Mikrosystemen einschließt; und
Entfernen von mindestens einem Teil des Substrats, um die Substratbondingflächen freizulegen.

16. Wafer-Level-Verfahren zum Packaging integrierter Schaltungen, wobei das Verfahren umfasst:
Durchführen des Verfahrens nach Anspruch 10 oder 11;
Bilden einer ersten passiven Komponente in mindestens einer von der Mehrzahl von Epoxyschichten, wobei die erste passive Komponente über mindestens eine der Zwischenverbindungsschichten elektrisch an die integrierte Schaltung gekoppelt ist.

17. Verfahren nach Anspruch 16, wobei die erste passive Komponente ein Dünnfilmwiderstand ist und die Bildung der ersten passiven Komponente durch Sputtern eines leitenden Metalls über mindestens eine der Epoxyschichten durchgeführt wird, um den Dünnfilmwiderstand zu bilden.

18. Verfahren nach Anspruch 16 oder 17, wobei die erste passive Komponente ein Kondensator ist und die Bildung der ersten passiven Komponente Bilden von Metallschichten und einer dielektrischen Schicht einschließt, so dass die dielektrische Schicht sandwichartig zwischen der ersten und zweiten Metallschicht angeordnet ist.

19. Verfahren nach einem der Ansprüche 16, 17 und 18, wobei die erste passive Komponente ein magnetischer Kern ist und die Bildung der ersten passiven Komponente Sputtern eines ferromagnetischen Materials auf mindestens eine der Epoxyschichten einschließt, um den magnetischen Kern zu bilden.

## Revendications

1. Boîtier de circuit intégré comprenant :
une pluralité de couches empilées immédiatement adjacentes (106a-106f) de résine époxy durcie, planarisante, photo-imageable ;
au moins une couche d'interconnexion (122a), chaque couche d'interconnexion étant incorporée dans une couche de résine époxy associée et comportant une pluralité de traces d'interconnexion ;
une pluralité de plots d'entrée/sortie (120) exposés sur une première surface du boîtier ; et
un premier circuit intégré (114a) positionné à l'intérieur d'au moins une des couches de résine époxy (106a-106f) et ayant une surface active, au moins une des couches de résine époxy s'étendant par-dessus la surface active du premier circuit intégré et le premier circuit intégré (114a) étant électriquement couplé à au moins un plot d'entrée/sortie associé (120) au moins en partie par le biais de l'au moins une couche d'interconnexion (122a) ;
le circuit comprenant un substrat (102, 902) constitué de silicium qui comporte une surface supérieure et une surface inférieure opposée, une première cavité se trouvant dans la surface supérieure de substrat, le premier circuit intégré (114a) étant positionné à l'intérieur de la première cavité, **caractérisé en ce qu'**une ou plusieurs régions du substrat sont dopées à une première concentration de dopage de telle sorte que le substrat est électriquement et thermiquement conducteur, aidant ainsi le premier circuit intégré (114a) à transmettre de la chaleur à une surface extérieure du boîtier de circuit intégré.

2. Boîtier de la revendication 1 comprenant une pluralité de dispositifs passifs dont un d'un groupe constitué par : un condensateur, une résistance, un dispositif MEMS, un capteur, une structure de batterie en couche mince, une antenne RF sans fil, un superchargeur, un commutateur photovoltaïque intégré et une bobine d'induction.

3. Boîtier de l'une quelconque des revendications précédentes dans lequel la pluralité de couches empilées immédiatement adjacentes (106a-106f) sont formées à partir de SU-8.

4. Boîtier de l'une quelconque des revendications précédentes comprenant au moins un caloduc (488) incorporé à l'intérieur d'au moins une des couches de résine époxy (106a-106f), l'au moins un caloduc (488) couplant thermiquement le premier circuit intégré (114a) avec une surface externe du boîtier, conduisant ainsi de la chaleur du premier circuit intégré à l'extérieur du boîtier.

5. Boîtier de l'une quelconque des revendications précédentes, le boîtier étant formé sur un substrat, le substrat comportant une pluralité de trous d'interconnexion conducteurs (313) et un composant capteur, le composant capteur et certaines de l'au moins une couche d'interconnexion étant électriquement couplés par le biais de certains de la pluralité de trous d'interconnexion conducteurs (313) et le composant capteur en étant au moins un d'un groupe constitué par : une cellule photovoltaïque, un biocapteur, un capteur de gaz, un capteur d'accélération, un capteur de vibrations, un capteur chimique, un capteur électromagnétique, un capteur de température et un capteur d'humidité.

6. Boîtier de circuit intégré de la revendication 1 dans lequel :
le substrat (102 ; 902 ; 1002) comporte une région de contact de terre (1014) ayant une deuxième concentration de dopage sensiblement supérieure à la première concentration de dopage, la région de contact de terre étant positionnée à la surface supérieure du substrat (102 ; 902 ; 1002) ;
le boîtier de circuit intégré comprend en outre une interconnexion de terre (1020) formée à partir d'un matériau électriquement conducteur, l'interconnexion de terre (1020) s'étendant entièrement à travers la première couche de résine époxy et étant électriquement connectée à la région de contact de terre (1014) dans le substrat ; et
le premier circuit intégré (906 ; 114a ; 1004) comporte un contact de terre qui est électriquement couplé avec la ou les régions dopées du substrat, dans lequel l'interconnexion de terre (1020), la région de contact de terre (1014) du substrat, le contact de terre sur le premier circuit intégré et la ou les régions dopées du substrat sont agencés pour être mis électriquement à la terre et électriquement couplés les uns aux autres.

7. Boîtier de circuit intégré de la revendication 1 ou la revendication 6 dans lequel le substrat est constitué au moins partiellement d'un matériau optiquement transparent et dans lequel le premier circuit intégré comporte un premier dispositif optique, le boîtier de circuit intégré comprenant en outre :
une deuxième cavité dans la surface inférieure du substrat ; et
un deuxième circuit intégré positionné dans la deuxième cavité, le deuxième circuit intégré étant positionné à l'opposé du premier circuit intégré et comportant un deuxième dispositif optique agencé pour communiquer optiquement avec le premier dispositif optique dans le premier circuit intégré par le biais d'une partie optiquement transparente du substrat.

8. Boîtier de circuit intégré de l'une quelconque des revendications 1, 6 dans lequel il y a un entrefer entre les parois latérales de la première cavité et le premier circuit intégré positionné à l'intérieur de la première cavité, laissant ainsi de la place au premier circuit intégré pour se dilater à l'intérieur de la première cavité.

9. Agencement de mise en boîtier comprenant :
un substrat (102) ayant une première surface et une deuxième surface opposée, certains d'une pluralité de trous d'interconnexion métalliques (313) pénétrant entièrement à travers le substrat et se terminant au niveau de certains d'une pluralité de plots de contact externes sur la deuxième surface du substrat ;
le boîtier de l'une quelconque des revendications précédentes formé sur la première surface du substrat (902, 102), certains de la pluralité de plots d'entrée/sortie (120) s'alignant avec certains de la pluralité de trous d'interconnexion métalliques (313), de telle sorte que l'au moins une couche d'interconnexion du boîtier est électriquement couplée avec au moins un de la pluralité de plots de contact externes (120) du substrat ; et
un matériau de moulage (464) qui recouvre la première surface du substrat et encapsule le boîtier.

10. Procédé de mise en boîtier de circuits intégrés, le procédé comprenant :
le dépôt successif de couches de résine époxy sur un substrat pour former une multiplicité de couches planarisées de résine époxy sur le substrat, les couches de résine époxy étant déposées par dépôt à la tournette, une couche de résine époxy supérieure étant présente ;
la structuration photolithographique d'au moins certaines des couches de résine époxy après qu'elles ont été déposées et avant que la couche de résine époxy suivante soit déposée ;
la formation d'ouvertures dans au moins certaines des couches de résine époxy structurées après qu'elles ont été structurées et avant que la couche de résine époxy suivante soit déposée ;
le positionnement d'un premier circuit intégré à l'intérieur d'une ouverture associée parmi les ouvertures, le premier circuit intégré ayant une pluralité de plots de connexion d'entrée/sortie et au moins une des couches de résine époxy étant déposées après le positionnement du premier circuit intégré pour recouvrir ainsi le premier circuit intégré ;
la formation d'au moins une couche d'interconnexion conductrice, chaque couche d'interconnexion étant formée par-dessus une couche de résine époxy associée ;
la formation d'une multiplicité de contacts externes de boîtier, le premier circuit intégré étant électriquement connecté à une pluralité des contacts externes de boîtier au moins en partie par le biais d'au moins une des couches d'interconnexion conductrices ; et
la formation d'une première cavité dans la surface supérieure du substrat et le positionnement du premier circuit intégré positionné à l'intérieur de la première cavité ;
dans lequel le substrat est constitué de silicium et comporte une surface supérieure et une surface inférieure opposée, une ou plusieurs régions du substrat étant dopées à une première concentration de dopage de telle sorte que le substrat est électriquement et thermiquement conducteur, aidant ainsi le premier circuit intégré à transmettre de la chaleur à une surface extérieure du boîtier de circuit intégré.

11. Procédé de la revendication 10 comprenant :
la formation d'ouvertures dans une première couche des couches de résine époxy déposées ;
le recouvrement de la première couche des couches de résine époxy déposées avec une couche de germination, de telle sorte que la couche de germination recouvre au moins sensiblement des fonds et des parois latérales des ouvertures dans la première couche et une surface de la première couche ;
le dépôt d'une couche de résine photosensible sur la couche de germination ;
la structuration photolithographique de la couche de résine photosensible déposée ;
le retrait de parties de la couche de résine photosensible, pour exposer ainsi des parties de la couche de germination ; et
le dépôt électrolytique d'un matériau conducteur sur les parties exposées de la couche de germination, de telle sorte que le matériau conducteur s'accumule de façon sensiblement simultanée sur la surface de la première couche, les fonds et les parois latérales des ouvertures dans la première couche, formant ainsi une couche d'interconnexion ayant au moins une trace conductrice et au moins un trou d'interconnexion conducteur.

12. Procédé de la revendication 10 ou 11 comprenant en outre la formation d'au moins un caloduc, chaque caloduc étant formé par-dessus une couche de résine époxy associée et couplant thermiquement le circuit intégré avec au moins une surface extérieure du boîtier, et dans lequel la formation d'une de l'au moins une couche d'interconnexion est effectuée sensiblement au même moment que la formation d'un de l'au moins un caloduc.

13. Procédé au niveau tranche de formation d'un boîtier de circuit intégré comprenant :
l'obtention d'un substrat ayant une première surface et une deuxième surface opposée, le substrat ayant des trous d'interconnexion métalliques qui s'étendent entre les première et deuxième surfaces du substrat ;
la formation d'une pluralité de microsystèmes sur la première surface du substrat par la réalisation du procédé de la revendication 10 ou 11, chaque microsystème comportant :
la multiplicité de couches de résine époxy planarisées ;
l'au moins une couche d'interconnexion, chaque couche d'interconnexion étant incorporée dans une couche de résine époxy associée ; et
le premier circuit intégré positionné à l'intérieur d'au moins une couche de résine époxy associée ;
la formation des couches d'interconnexion de la pluralité de microsystèmes de telle sorte que certaines des couches d'interconnexion soient électriquement couplées avec certains des trous d'interconnexion métalliques ;
l'application d'un matériau de moulage par-dessus la première surface du substrat pour former une structure moulée, pour encapsuler ainsi chacun de la pluralité de microsystèmes ; et
l'individualisation de la structure moulée pour former des boîtiers de circuit intégré individuels, chaque boîtier de circuit intégré comportant au moins un des microsystèmes.

14. Procédé de la revendication 13 dans lequel l'obtention du substrat comprend :
la gravure de la deuxième surface du substrat pour former la cavité dans le substrat ;
la formation d'un élément de détection à l'intérieur de la cavité, l'élément de détection en étant un d'un groupe constitué par : une cellule photovoltaïque, un biocapteur, un capteur de gaz, un capteur chimique, un capteur électromagnétique, un capteur d'accélération, un capteur de vibrations, un capteur d'humidité, et une antenne sans fil en réseau phasé ;
le retrait de parties du substrat pour former des trous dans le substrat ; et
le dépôt électrolytique d'un matériau conducteur dans le substrat pour former les trous d'interconnexion métalliques, au moins certains des trous d'interconnexion métalliques étant électriquement couplés à l'élément de détection.

15. Procédé de formation d'un boîtier de circuit intégré :
l'obtention d'un substrat ayant une première surface et une deuxième surface opposée ;
l'application d'un matériau conducteur sur la première surface du substrat pour former des plots de connexion de substrat ;
la formation d'une pluralité de microsystèmes sur la première surface du substrat par la réalisation du procédé de la revendication 10 ou 11, chaque microsystème comportant :
la multiplicité de couches de résine époxy planarisées ;
l'au moins une couche d'interconnexion, chaque couche d'interconnexion étant incorporée dans une couche de résine époxy associée ; et
le premier circuit intégré positionné à l'intérieur d'au moins une couche de résine époxy associée ;
la formation des couches d'interconnexion de la pluralité de microsystèmes de telle sorte que certaines des couches d'interconnexion soient électriquement couplées avec certains des plots de connexion de substrat ;
l'application d'un matériau de moulage par-dessus la première surface du substrat pour former une structure de tranche moulée, pour encapsuler ainsi chacun de la pluralité de microsystèmes ;
l'individualisation de la structure de tranche moulée pour former des boîtiers de circuit intégré individuels, chaque boîtier de circuit intégré comportant au moins un de la pluralité de microsystèmes ; et
le retrait d'au moins une partie du substrat pour exposer les plots de connexion de substrat.

16. Procédé au niveau tranche de mise en boîtier de circuits intégrés, le procédé comprenant :
la réalisation du procédé de la revendication 10 ou 11 ;
la formation d'un premier composant passif à l'intérieur d'au moins une de la multiplicité de couches de résine époxy, le premier composant passif étant électriquement couplé avec le circuit intégré par le biais d'au moins une des couches d'interconnexion.

17. Procédé de la revendication 16 dans lequel le premier composant passif est une résistance en couche mince et la formation du premier composant passif est effectuée en pulvérisant un métal conducteur sur au moins une des couches de résine époxy pour former la résistance en couche mince.

18. Procédé de la revendication 16 ou 17 dans lequel le premier composant passif est un condensateur et la formation du premier composant passif comporte la formation de couches métalliques et d'une couche diélectrique de telle sorte que la couche diélectrique soit intercalée entre les première et deuxième couches métalliques.

19. Procédé de l'une quelconque des revendications 16, 17 et 18 dans lequel le premier composant passif est un noyau magnétique et la formation du premier composant passif comporte la pulvérisation d'un matériau ferromagnétique sur au moins une des couches de résine époxy pour former le noyau magnétique.
